# EUROPEAN PATENT SPECIFICATION

(11) **EP 2 025 013 B1**
(45) Date of publication and mention of the grant of the patent: **17.11.2010**
(21) Application number: 07795781.9
(22) Date of filing: 05.06.2007
(51) Int. Cl.: H01L 51/00

(54) **PROCESS FOR MAKING AN ORGANIC ELECTRONIC DEVICE**
VERFAHREN ZUR HERSTELLUNG EINER ORGANISCHEN ELEKTROVORRICHTUNG
PROCEDE POUR FABRIQUER UN DISPOSITIF ELECTRONIQUE ORGANIQUE

(30) Priority: 05.06.2006 US 811047 P
(43) Date of publication of application: 18.02.2009
(73) Proprietor: E.I. DU PONT DE NEMOURS AND COMPANY, Wilmington, DE 19898 (US)
(72) Inventor: FEEHERY, William, F., Santa Barbara, California 93117 (US)
(74) Representative: Towler, Philip Dean
(86) International application number: PCT/US2007/013285
(87) International publication number: WO 2007/145977

(56) References cited:
- EP-A- 1 647 566
- US-A1- 2005 196 969
- BURNS S E ET AL: "PRINTING OF POLYMER THIN-FILM TRANSISTORS FOR ACTIVE-MATRIX-DISPLAY APPLICATIONS" JOURNAL OF THE SOCIETY FOR INFORMATION DISPLAY, SOCIETY FOR INFORMATION DISPLAY, SAN JOSE, US, vol. 11, no. 4, 2003, pages 599-604, XP001194761 ISSN: 1071-0922

## Description

### BACKGROUND INFORMATION

### Field of the Disclosure

This disclosure relates in general to a process for making an organic electronic device. It further relates to the device made with the process.

### Description of the Related Art

Organic electronic devices define a category of products that include an active layer. Such devices convert electrical energy into radiation, detect signals through electronic processes, convert radiation into electrical energy, or include one or more organic semiconductor layers.

Organic light-emitting diodes (OLEDs) are organic electronic devices comprising an organic layer capable of electroluminescence. OLEDs can have the following configuration:
anode/buffer layer/EL material/cathode

The anode is typically any material that is transparent and has the ability to inject holes into the EL material, such as, for example, indium/tin oxide (ITO). The anode is optionally supported on a glass or plastic substrate. EL materials include fluorescent compounds, fluorescent and phosphorescent metal complexes, conjugated polymers, and mixtures thereof. The cathode is typically any material (such as, e.g., Ca or Ba) that has the ability to inject electrons into the EL material. The buffer layer is typically an electrically conducting polymer and facilitates the injection of holes from the anode into the EL material layer. The buffer layer may also have other properties which facilitate device performance.

Current research in the production of full-color OLEDs is directed toward the development of cost effective, high throughput processes for producing color pixels. For the manufacture of monochromatic displays by liquid processing, spin-coating processes have been widely adopted (see, e.g., David Braun and Alan J. Heeger, Appl. Phys. Letters 58, 1982 (1991)). However, manufacture of full-color displays requires certain modifications to procedures used in manufacture of monochromatic displays. For example, to make a display with full-color images, each display pixel is divided into three subpixels, each emitting one of the three primary display colors, red, green, and blue. This division of full-color pixels into three subpixels has resulted in a need to modify current processes to prevent the spreading of the liquid colored materials (i.e., inks) and color mixing.

Several methods for providing ink containment are described in the literature see for example US 2005/196969. These are based on containment structures, surface tension discontinuities, and combinations of both. Containment structures are geometric obstacles to spreading: pixel wells, banks, etc. In order to be effective these structures must be large, comparable to the wet thickness of the deposited materials. When the emissive ink is printed into these structures it wets onto the structure surface, so thickness uniformity is reduced near the structure. Therefore the structure must be moved outside the emissive "pixel" region so the non-uniformities are not visible in operation. Due to limited space on the display (especially high-resolution displays) this reduces the available emissive area of the pixel. Practical containment structures generally have a negative impact on quality when depositing continuous layers of the charge injection and transport layers. Consequently, all the layers must be printed.

There is a continuing need for improved processes for making the layers in such devices.

### SUMMARY

There is provided a process for forming an organic electronic device. The process comprises:
forming a first layer comprising an electrically conductive material and a fluorinated acid polymer, said first layer having a first surface energy;
forming a second layer over the first layer, said second layer having a second surface energy which is greater than the first surface energy;
removing selected portions of the second layer, resulting in uncovered areas of the first layer;
forming a third layer over the uncovered areas of the first layer.

In one embodiment, the first layer is a hole injection layer having a work function greater than 5.2 eV, and the second layer is a hole transport layer.

In a nother embodiment, the first layer is a hole injection layer having a work function greater than 5.0 eV and made from a composition having a pH of greater than 2.0, and the second layer is a hole transport layer.

In another embodiment, there is provided an electronic device made by the above process. The device has an anode. The anode is in contact with the first layer, which is a hole injection layer having a work function greater than 5.2eV. The hole injection layer is in contact with a hole transport layer.

The foregoing general description and the following detailed description are exemplary and explanatory only and are not restrictive of the invention, as defined in the appended claims.

### BRIEF DESCRIPTION OF THE DRAWINGS

Embodiments are illustrated in the accompanying figures to improve understanding of concepts as presented herein.
FIG. 1 includes a diagram illustrating contact angle.
FIG. 2 includes an illustration of an electronic device.

Skilled artisans appreciate that objects in the figures are illustrated for simplicity and clarity and have not necessarily been drawn to scale. For example, the dimensions of some of the objects in the figures may be exaggerated relative to other objects to help to improve understanding of embodiments.

### DETAILED DESCRIPTION

Many aspects and embodiments have been described above and are merely exemplary and not limiting. After reading this specification, skilled artisans appreciate that other aspects and embodiments are possible without departing from the scope of the invention.

Other features and benefits of any one or more of the embodiments will be apparent from the following detailed description, and from the claims. The detailed description first addresses Definitions and Clarification of Terms followed by the First Layer, the Second and Third Layers, the Process, Electronic Devices, and finally, Examples.

### 1. Definitions and Clarification of Terms

Before addressing details of embodiments described below, some terms are defined or clarified.

As used herein the term "conductor" and its variants are intended to refer to a layer material, member, or structure having an electrical property such that current flows through such layer material, member, or structure without a substantial drop in potential. The term is intended to include semiconductors. In one embodiment, a conductor will form a layer having a conductivity of at least 10⁻⁶ S/cm.

The term "electrically conductive material" refers to a material which is inherently or intrinsically capable of electrical conductivity without the addition of carbon black or conductive metal particles.

The term "work function" is intended to mean the minimum energy needed to remove an electron from a conductive material to a point at infinite distance away from the surface. The work-function is commonly obtained by UPS (Ultraviolet Photoemission Spectroscopy) or Kelvin-probe contact potential differential measurement.

The term "energy potential" is intended to mean potential of a nonconducting material sandwiched between a conducting specimen and a vibrating tip of Kelvin probe. The conducting specimen can be, but not limited to either gold, indium tin oxide, or electrically conducting polymers.

The term "hole injection" when referring to a layer, material, member, or structure, is intended to mean such layer, material, member, or structure facilitates injection and migration of positive charges through the thickness of such layer, material, member, or structure with relative efficiency and small loss of charge.

"Hole transport" when referring to a layer, material, member, or structure, is intended to mean such layer, material, member, or structure facilitates migration of positive charges through the thickness of such layer, material, member, or structure with relative efficiency and small loss of charge. As used herein, the term "hole transport layer" does not encompass a light-emitting layer, even though that layer may have some hole transport properties.

The term "organic solvent wettable" refers to a material which, when formed into a film, is wettable by organic solvents. The term also includes polymeric acids which are not film-forming alone, but which form an electrically conductive polymer composition which is wettable. In one embodiment, organic solvent wettable materials form films which are wettable by phenylhexane with a contact angle no greater than 40°.

The term "fluorinated acid polymer" refers to a polymer having acidic groups, where at least some of the hydrogens have been replaced by fluorine. The term "acidic group" refers to a group capable of ionizing to donate a hydrogen ion to a Brønsted base.

The term "surface energy" is the energy required to create a unit area of a surface from a material. A characteristic of surface energy is that liquid materials with a given surface energy will not wet surfaces with a lower surface energy. The term surface energy with respect to liquid materials is intended to have the same meaning as surface tension.

The term "layer" is used interchangeably with the term "film" and refers to a coating covering a desired area. The term is not limited by size. The area can be as large as an entire device or as small as a specific functional area such as the actual visual display, or as small as a single sub-pixel. Layers and films can be formed by any conventional deposition technique, including vapor deposition, liquid deposition (continuous and discontinuous techniques), and thermal transfer.

As used herein, the terms "comprises," "comprising," "includes," "including," "has," "having" or any other variation thereof, are intended to cover a non-exclusive inclusion. For example, a process, method, article, or apparatus that comprises a list of elements is not necessarily limited to only those elements but may include other elements not expressly listed or inherent to such process, method, article, or apparatus. Further, unless expressly stated to the contrary, "or" refers to an inclusive or and not to an exclusive or. For example, a condition A or B is satisfied by any one of the following: A is true (or present) and B is false (or not present), A is false (or not present) and B is true (or present), and both A and B are true (or present).

Also, use of "a" or "an" are employed to describe elements and components described herein. This is done merely for convenience and to give a general sense of the scope of the invention. This description should be read to include one or at least one and the singular also includes the plural unless it is obvious that it is meant otherwise.

Group numbers corresponding to columns within the Periodic Table of the elements use the "New Notation" convention as seen in the CRC Handbook of Chemistry and Physics, 81st Edition (2000-2001).

Unless otherwise defined, all technical and scientific terms used herein have the same meaning as commonly understood by one of ordinary skill in the art to which this invention belongs. Although methods and materials similar or equivalent to those described herein can be used in the practice or testing of embodiments of the present invention, suitable methods and materials are described below. All publications, patent applications, patents, and other references mentioned herein are incorporated by reference in their entirety, unless a particular passage is cited In case of conflict, the present specification, including definitions, will control. In addition, the materials, methods, and examples are illustrative only and not intended to be limiting.

To the extent not described herein, many details regarding specific materials, processing acts, and circuits are conventional and may be found in textbooks and other sources within the organic light-emitting diode display, lighting source, photodetector, photovoltaic, and semiconductive member arts.

### 2. First Layer

The first layer comprises an electrically conductive material and a fluorinated acid polymer ("FAP"). The surface energy of this layer is generally low. In some embodiments, the layer is not wettable with phenylhexane. Phenylhexane will form a contact angle of at least 70° on the first layer.

In one embodiment, the first layer has a work function of greater than 5.2 eV. In one embodiment, the first layer has a work function greater than 5.3 eV. In one embodiment, the first layer was a work function greater than 5.5 eV. In one embodiment, the first layer has a work function of greater than 5.0 eV and is formed from a liquid composition having a pH greater than 2. The term "liquid composition" is intended to mean a liquid medium in which a material is dissolved to form a solution; a liquid medium in which a material is dispersed to form a dispersion, or a liquid medium in which a material is suspended to form a suspension or an emulsion. The term "liquid medium" is intended to mean a liquid material, including a pure liquid, a combination of liquids, a solution, a dispersion, a suspension, and an emulsion. Liquid medium is used regardless whether one or more solvents are present. In one embodiment, the liquid medium is a solvent or combination of two or more solvents. Any solvent or combination of solvents can be used so long as a layer of the conductive material can be formed. The liquid medium may include other materials, such as coating aids.

In one embodiment, the conductive material is selected from the group consisting of inorganic oxides, conducting polymers, and combinations thereof.

### a. Inorganic Oxide

In one embodiment, the electrically conductive material comprises an inorganic oxide in combination with a fluorinated acid polymer.

In some embodiments, the inorganic oxide is a semiconductive oxide and comprises an oxide of an element selected from group 2 through group 12 of the periodic table. In one embodiment, semiconductive oxide materials comprise an oxide of an element selected from group 2 and group 12. Group numbers corresponding to columns within the periodic table of the elements use the "New Notation" convention as seen in the CRC Handbook of Chemistry and Physics, 81st Edition (2000), where the groups are numbered from left to right as 1-18.

In one embodiment, the inorganic semiconductive material is an inorganic oxide, such as NiₓCoₓ₋₁O_{3/4} (Science, p1273 - 1276, vol 305, Aug. 27, 2004), indium, zirconium, or antimony doped oxide.

### b. Formation of Inorganic Oxide Compositions with Fluorinated Acid Polymers

In one embodiment, the composition for forming the first layer comprises at least one inorganic oxide and at least one fluorinated acid polymer. The compositions can be formed by blending the semiconductive oxide particles with the FAP. In some embodiments, this can be accomplished by adding an aqueous dispersion of the semiconductive oxide particles to an aqueous dispersion or solution of the FAP. In some embodiments, the dispersions or solutions are formed in semi-aqueous or non-aqueous media. In one embodiment, the composition is further treated using sonication or microfluidization to ensure mixing of the components.

In one embodiment, one or both of the components are isolated in solid form. The solid material can be redispersed in water or in an aqueous solution or dispersion of the other component. For example, semiconductive oxide particle solids can be dispersed in an aqueous solution or dispersion of an FAP. In some embodiments, semi-aqueous or non-aqueous media are used in place of water.

In one embodiment, the composition further comprises a conductive polymer. The conductive polymer can be added at any point.

In one embodiment, the composition for forming the first layer comprises at least one inorganic oxide and at least one conductive polymer doped with an FAP. The compositions can be formed by blending the semiconductive oxide particles with the FAP-doped conductive polymer, as described above with respect to the FAP alone. However, in many cases the FAP-doped conductive polymer is not redispersible in aqueous solution once it is isolated as a solid.

### c. Conductive Polymer

In one embodiment, the electrically conductive material comprises at least one conductive polymer. The term "polymer" is intended to refer to compounds having at least three repeating units and encompasses homopolymers and copolymers. In some embodiments, the electrically conductive polymer is conductive in a protonated form and not conductive in an unprotonated form. Any conductive polymer can be used so long as the hole injection layer has the desired work function.

In one embodiment, the conducting polymer is doped with at least one fluorinated acid polymer. The term "doped" is intended to mean that the electrically conductive polymer has a polymeric counter-ion derived from a polymeric acid to balance the charge on the conductive polymer.

In one embodiment, the conducting polymer is in admixture with the fluorinated acid polymer. In one embodiment, the conductive polymer is doped with at least one non-fluorinated polymeric acid and is in admixture with at least one fluorinated acid polymer.

In one embodiment, the electrically conductive polymer will form a film which has a conductivity of at least 10⁻⁷ S/cm. The monomer from which the conductive polymer is formed, is referred to as a "precursor monomer". A copolymer will have more than one precursor monomer.

In one embodiment, the conductive polymer is made from at least one precursor monomer selected from thiophenes, pyrroles, anilines, and polycyclic aromatics. The polymers made from these monomers are referred to herein as polythiophenes, polyselenophenes, poly(tellurophenes), polypyrroles, polyanilines, and polycyclic aromatic polymers, respectively. The term "polycyclic aromatic" refers to compounds having more than one aromatic ring. The rings may be joined by one or more bonds, or they may be fused together. The term "aromatic ring" is intended to include heteroaromatic rings. A "polycyclic heteroaromatic" compound has at least one heteroaromatic ring. In one embodiment, the polycyclic aromatic polymers are poly(thienothiophenes).

In one embodiment, thiophene monomers contemplated for use to form the electrically conductive polymer in the composition comprise Formula I below: 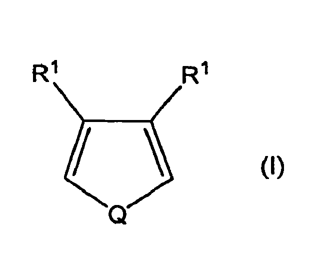 wherein:
- Q: is selected from the group consisting of S, Se, and Te;
- R¹: is independently selected so as to be the same or different at each occurrence and is selected from hydrogen, alkyl, alkenyl, alkoxy, alkanoyl, alkythio, aryloxy, alkylthioalkyl, alkylaryl, arylalkyl, amino, alkylamino, dialkylamino, aryl, alkylsulfinyl, alkoxyalkyl, alkylsulfonyl, arylthio, arylsulfinyl, alkoxycarbonyl, arylsulfonyl, acrylic acid, phosphoric acid, phosphonic acid, halogen, nitro, cyano, hydroxyl, epoxy, silane, siloxane, alcohol, benzyl, carboxylate, ether, ether carboxylate, amidosulfonate, ether sulfonate, ester sulfonate, and urethane; or both R¹ groups together may form an alkylene or alkenylene chain completing a 3, 4, 5, 6, or 7-membered aromatic or alicyclic ring, which ring may optionally include one or more divalent nitrogen, selenium, tellurium, sulfur or oxygen atoms.

As used herein, the term "alkyl" refers to a group derived from an aliphatic hydrocarbon and includes linear, branched and cyclic groups which may be unsubstituted or substituted. The term "heteroalkyl" is intended to mean an alkyl group, wherein one or more of the carbon atoms within the alkyl group has been replaced by another atom, such as nitrogen, oxygen, sulfur, and the like. The term "alkylene" refers to an alkyl group having two points of attachment.

As used herein, the term "alkenyl" refers to a group derived from an aliphatic hydrocarbon having at least one carbon-carbon double bond, and includes linear, branched and cyclic groups which may be unsubstituted or substituted. The term "heteroalkenyl" is intended to mean an alkenyl group, wherein one or more of the carbon atoms within the alkenyl group has been replaced by another atom, such as nitrogen, oxygen, sulfur, and the like. The term "alkenylene" refers to an alkenyl group having two points of attachment.

As used herein, the following terms for substituent groups refer to the formulae given below:

| | |
|---|---|
| "alcohol" | -R³-OH |
| "amido" | -R³-C(O)N(R⁶) R⁶ |
| "amidosulfonate" | -R³-C(O)N(R⁶) R⁴- SO₃Z |
| "benzyl" | -CH₂-C₆H₅ |
| "carboxylate" | -R³-C(O)O-Z or -R³-O-C(O)-Z |
| "ether" | -R³-(O-R⁵)ₚ-O-R⁵ |
| "ether carboxylate" | -R³-O-R⁴-C(O)O-Z or -R³-O-R⁴-O-C(O)-Z |
| "ether sulfonate" | -R³-O-R⁴-SO₃Z |
| "ester sulfonate" | -R³-O-C(O)-R⁴-SO₃Z |
| "sulfonimide" | -R³-SO₂-NH- SO₂-R⁵ |
| "urethane" | -R³-O-C(O)-N(R⁶)₂ |

where all "R" groups are the same or different at each occurrence and:
R³ is a single bond or an alkylene group
R⁴ is an alkylene group
R⁵ is an alkyl group
R⁶ is hydrogen or an alkyl group
p is 0 or an integer from 1 to 20
Z is H, alkali metal, alkaline earth metal, N(R⁵)₄ or R⁵
Any of the above groups may further be unsubstituted or substituted, and any group may have F substituted for one or more hydrogens, including perfluorinated groups. In one embodiment, the alkyl and alkylene groups have from 1-20 carbon atoms.

In one embodiment, in the thiophene monomer, both R¹ together form -O-(CHY)ₘ-O- , where m is 2 or 3, and Y is the same or different at each occurrence and is selected from hydrogen, halogen, alkyl, alcohol, amidosulfonate, benzyl, carboxylate, ether, ether carboxylate, ether sulfonate, ester sulfonate, and urethane, where the Y groups may be partially or fully fluorinated. In one embodiment, all Y are hydrogen. In one embodiment, the polythiophene is poly(3,4-ethylenedioxythiophene). In one embodiment, at least one Y group is not hydrogen. In one embodiment, at least one Y group is a substituent having F substituted for at least one hydrogen. In one embodiment, at least one Y group is perfluorinated.

In one embodiment, the thiophene monomer has Formula I(a): 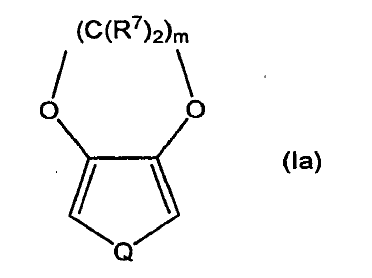 wherein:
- Q: is selected from the group consisting of S, Se, and Te;
- R⁷: is the same or different at each occurrence and is selected from hydrogen, alkyl, heteroalkyl, alkenyl, heteroalkenyl, alcohol, amidosulfonate, benzyl, carboxylate, ether, ether carboxylate, ether sulfonate, ester sulfonate, and urethane, with the proviso that at least one R⁷ is not hydrogen, and
- m: is 2 or 3.

In one embodiment of Formula I(a), m is two, one R⁷ is an alkyl group of more than 5 carbon atoms, and all other R⁷ are hydrogen. In one embodiment of Formula I(a), at least one R⁷ group is fluorinated. In one embodiment, at least one R⁷ group has at least one fluorine substituent. In one embodiment, the R⁷ group is fully fluorinated.

In one embodiment of Formula I(a), the R⁷ substituents on the fused alicyclic ring on the thiophene offer improved solubility of the monomers in water and facilitate polymerization in the presence of the fluorinated acid polymer.

In one embodiment of Formula I(a), m is 2, one R⁷ is sulfonic acid-propylene-ether-methylene and all other R⁷ are hydrogen. In one embodiment, m is 2, one R⁷ is propyl-ether-ethylene and all other R⁷ are hydrogen. In one embodiment, m is 2, one R⁷ is methoxy and all other R⁷ are hydrogen. In one embodiment, one R⁷ is sulfonic acid difluoromethylene ester methylene (-CH₂-O-C(O)-CF₂-SO₃H), and all other R⁷ are hydrogen.

In one embodiment, pyrrole monomers contemplated for use to form the electrically conductive polymer in the composition comprise Formula II below. 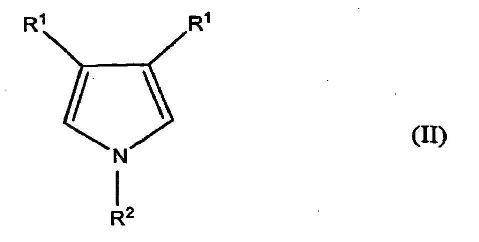 where in Formula II:
- R¹: is independently selected so as to be the same or different at each occurrence and is selected from hydrogen, alkyl, alkenyl, alkoxy, alkanoyl, alkythio, aryloxy, alkylthioalkyl, alkylaryl, arylalkyl, amino, alkylamino, dialkylamino, aryl, alkylsulfinyl, alkoxyalkyl, alkylsulfonyl, arylthio, arylsulfinyl, alkoxycarbonyl, arylsulfonyl, acrylic acid, phosphoric acid, phosphonic acid, halogen, nitro, cyano, hydroxyl, epoxy, silane, siloxane, alcohol, benzyl, carboxylate, ether, amidosulfonate, ether carboxylate, ether sulfonate, ester sulfonate, and urethane; or both R¹ groups together may form an alkylene or alkenylene chain completing a 3, 4, 5, 6, or 7-membered aromatic or alicyclic ring, which ring may optionally include one or more divalent nitrogen, sulfur, selenium, tellurium, or oxygen atoms; and
- R²: is independently selected so as to be the same or different at each occurrence and is selected from hydrogen, alkyl, alkenyl, aryl, alkanoyl, alkylthioalkyl, alkylaryl, arylalkyl, amino, epoxy, silane, siloxane, alcohol, benzyl, carboxylate, ether, ether carboxylate, ether sulfonate, ester sulfonate, and urethane.

In one embodiment, R¹ is the same or different at each occurrence and is independently selected from hydrogen, alkyl, alkenyl, alkoxy, cycloalkyl, cycloalkenyl, alcohol, benzyl, carboxylate, ether, amidosulfonate, ether carboxylate, ether sulfonate, ester sulfonate, urethane, epoxy, silane, siloxane, and alkyl substituted with one or more of sulfonic acid, carboxylic acid, acrylic acid, phosphoric acid, phosphonic acid, halogen, nitro, cyano, hydroxyl, epoxy, silane, or siloxane moieties.

In one embodiment, R² is selected from hydrogen, alkyl, and alkyl substituted with one or more of sulfonic acid, carboxylic acid, acrylic acid, phosphoric acid, phosphonic acid, halogen, cyano, hydroxyl, epoxy, silane, or siloxane moieties.

In one embodiment, the pyrrole monomer is unsubstituted and both R¹ and R² are hydrogen.

In one embodiment, both R¹ together form a 6- or 7-membered alicyclic ring, which is further substituted with a group selected from alkyl, heteroalkyl, alcohol, benzyl, carboxylate, ether, ether carboxylate, ether sulfonate, ester sulfonate, and urethane. These groups can improve the solubility of the monomer and the resulting polymer. In one embodiment, both R¹ together form a 6- or 7-membered alicyclic ring, which is further substituted with an alkyl group. In one embodiment, both R¹ together form a 6- or 7-membered alicyclic ring, which is further substituted with an alkyl group having at least 1 carbon atom.

In one embodiment, both R¹ together form -O-(CHY)ₘ-O- , where m is 2 or 3, and Y is the same or different at each occurrence and is selected from hydrogen, alkyl, alcohol, benzyl, carboxylate, amidosulfonate, ether, ether carboxylate, ether sulfonate, ester sulfonate, and urethane. In one embodiment, at least one Y group is not hydrogen. In one embodiment, at least one Y group is a substituent having F substituted for at least one hydrogen. In one embodiment, at least one Y group is perfluorinated.

In one embodiment, aniline monomers contemplated for use to form the electrically conductive polymer in the composition comprise Formula III below. 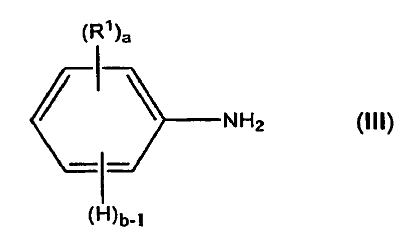 wherein:
a is 0 or an integer from 1 to 4;
b is an integer from 1 to 5, with the proviso that a + b = 5; and
R¹ is independently selected so as to be the same or different at each occurrence and is selected from hydrogen, alkyl, alkenyl, alkoxy, alkanoyl, alkythio, aryloxy, alkylthioalkyl, alkylaryl, arylalkyl, amino, alkylamino, dialkylamino, aryl, alkylsulfinyl, alkoxyalkyl, alkylsulfonyl, arylthio, arylsulfinyl, alkoxycarbonyl, arylsulfonyl, acrylic acid, phosphoric acid, phosphonic acid, halogen, nitro, cyano, hydroxyl, epoxy, silane, siloxane, alcohol, benzyl, carboxylate, ether, ether carboxylate, amidosulfonate, ether sulfonate, ester sulfonate, and urethane; or both R¹ groups together may form an alkylene or alkenylene chain completing a 3, 4, 5, 6, or 7-membered aromatic or alicyclic ring, which ring may optionally include one or more divalent nitrogen, sulfur or oxygen atoms.

When polymerized, the aniline monomeric unit can have Formula IV(a) or Formula IV(b) shown below, or a combination of both formulae. 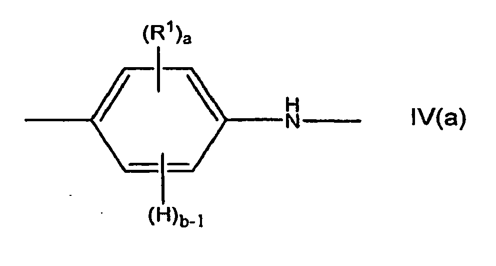 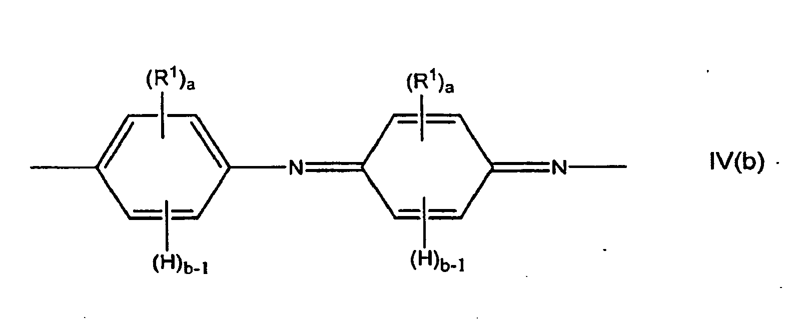 where a, b and R¹ are as defined above.

In one embodiment, the aniline monomer is unsubstituted and a = 0.

In one embodiment, a is not 0 and at least one R¹ is fluorinated. In one embodiment, at least one R¹ is perfluorinated.

In one embodiment, fused polycylic heteroaromatic monomers contemplated for use to form the electrically conductive polymer in the composition have two or more fused aromatic rings, at least one of which is heteroaromatic. In one embodiment, the fused polycyclic heteroaromatic monomer has Formula V: 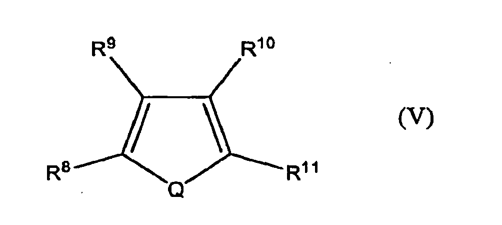 wherein:
Q is S, Se, Te, or NR⁶;
R⁶ is hydrogen or alkyl;
R⁸, R⁹, R¹⁰, and R¹¹ are independently selected so as to be the same or different at each occurrence and are selected from hydrogen, alkyl, alkenyl, alkoxy, alkanoyl, alkythio, aryloxy, alkylthioalkyl, alkylaryl, arylalkyl, amino, alkylamino, dialkylamino, aryl, alkylsulfinyl, alkoxyalkyl, alkylsulfonyl, arylthio, arylsulfinyl, alkoxycarbonyl, arylsulfonyl, acrylic acid, phosphoric acid, phosphonic acid, halogen, nitro, nitrile, cyano, hydroxyl, epoxy, silane, siloxane, alcohol, benzyl, carboxylate, ether, ether carboxylate, amidosulfonate, ether sulfonate, ester sulfonate, and urethane; and
at least one of R⁸ and R⁹, R⁹ and R¹⁰, and R¹⁰ and R¹¹ together form an alkenylene chain completing a 5 or 6-membered aromatic ring, which ring may optionally include one or more divalent nitrogen, sulfur,selenium, tellurium, or oxygen atoms.

In one embodiment, the fused polycyclic heteroaromatic monomer has Formula V(a), V(b), V(c), V(d), V(e), V(f), and V(g): 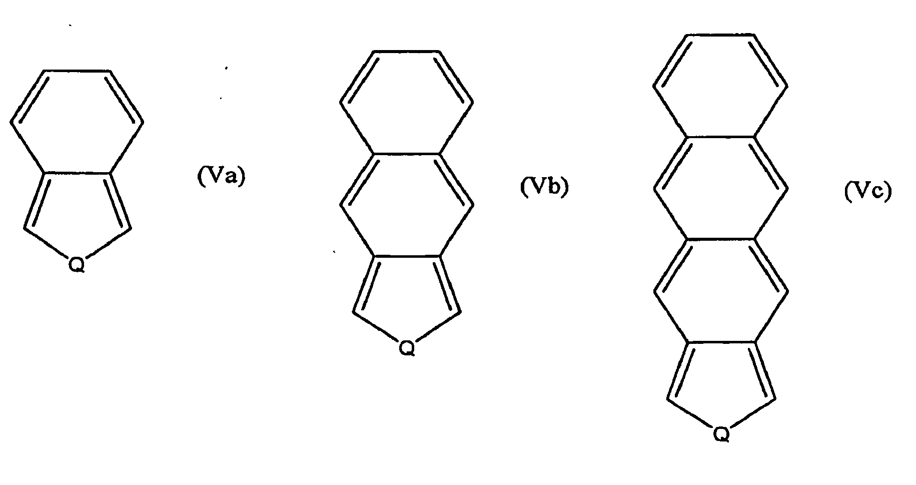 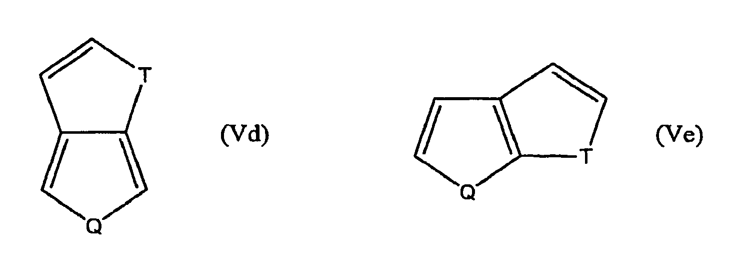 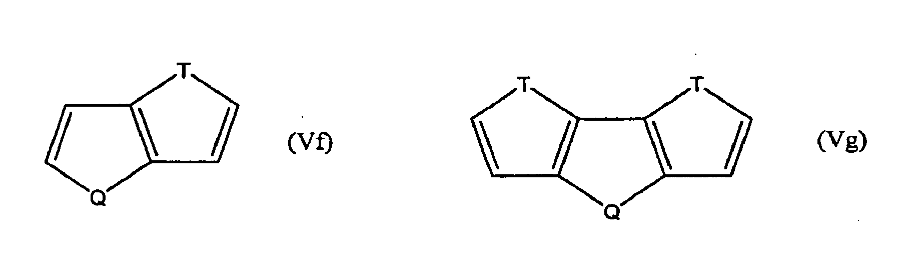 wherein:
Q is S, Se, Te, or NH; and
T is the same or different at each occurrence and is selected from S, NR⁶, O, SiR⁶₂, Se, Te, and PR⁶;
R⁶ is hydrogen or alkyl.
The fused polycyclic heteroaromatic monomers may be further substituted with groups selected from alkyl, heteroalkyl, alcohol, benzyl, carboxylate, ether, ether carboxylate, ether sulfonate, ester sulfonate, and urethane. In one embodiment, the substituent groups are fluorinated. In one embodiment, the substituent groups are fully fluorinated.

In one embodiment, the fused polycyclic heteroaromatic monomer is a thieno(thiophene). Such compounds have been discussed in, for example, Macromolecules, 34, 5746-5747 (2001); and Macromolecules, 35, 7281-7286 (2002). In one embodiment, the thieno(thiophene) is selected from thieno(2,3-b)thiophene, thieno(3,2-b)thiophene, and thieno(3,4-b)thiophene. In one embodiment, the thieno(thiophene) monomer is further substituted with at least one group selected from alkyl, heteroalkyl, alcohol, benzyl, carboxylate, ether, ether carboxylate, ether sulfonate, ester sulfonate, and urethane. In one embodiment, the substituent groups are fluorinated. In one embodiment, the substituent groups are fully fluorinated.

In one embodiment, polycyclic heteroaromatic monomers contemplated for use to form the polymer in the composition comprise Formula VI: 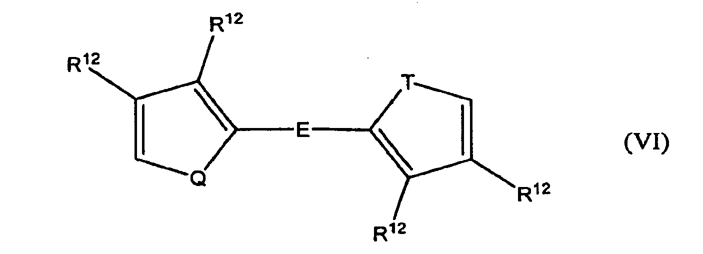 wherein:
Q is S, Se, Te, or NR⁶;
T is selected from S, NR⁶, O, SiR⁶₂, Se, Te, and PR⁶;
E is selected from alkenylene, arylene, and heteroarylene;
R⁶ is hydrogen or alkyl;
   R¹² is the same or different at each occurrence and is selected from hydrogen, alkyl, alkenyl, alkoxy, alkanoyl, alkythio, aryloxy, alkylthioalkyl, alkylaryl, arylalkyl, amino, alkylamino, dialkylamino, aryl, alkylsulfinyl, alkoxyalkyl, alkylsulfonyl, arylthio, arylsulfinyl, alkoxycarbonyl, arylsulfonyl, acrylic acid, phosphoric acid, phosphonic acid, halogen, nitro, nitrile, cyano, hydroxyl, epoxy, silane, siloxane, alcohol, benzyl, carboxylate, ether, ether carboxylate, amidosulfonate, ether sulfonate, ester sulfonate, and urethane; or both R¹² groups together may form an alkylene or alkenylene chain completing a 3, 4, 5, 6, or 7-membered aromatic or alicyclic ring, which ring may optionally include one or more divalent nitrogen, sulfur, selenium, tellurium, or oxygen atoms.

In one embodiment, the electrically conductive polymer is a copolymer of a precursor monomer and at least one second monomer. Any type of second monomer can be used, so long as it does not detrimentally affect the desired properties of the copolymer. In one embodiment, the second monomer comprises no more than 50% of the polymer, based on the total number of monomer units. In one embodiment, the second monomer comprises no more than 30%, based on the total number of monomer units. In one embodiment, the second monomer comprises no more than 10%, based on the total number of monomer units.

Exemplary types of second monomers include, but are not limited to, alkenyl, alkynyl, arylene, and heteroarylene. Examples of second monomers include, but are not limited to, fluorene, oxadiazole, thiadiazole, benzothiadiazole, phenylenevinylene, phenyleneethynylene, pyridine, diazines, and triazines, all of which may be further substituted.

In one embodiment, the copolymers are made by first forming an intermediate precursor monomer having the structure A-B-C, where A and C represent precursor monomers, which can be the same or different, and B represents a second monomer. The A-B-C intermediate precursor monomer can be prepared using standard synthetic organic techniques, such as Yamamoto, Stille, Grignard metathesis, Suzuki, and Negishi couplings. The copolymer is then formed by oxidative polymerization of the intermediate precursor monomer alone, or with one or more additional precursor monomers.

In one embodiment, the electrically conductive polymer is a copolymer of two or more precursor monomers. In one embodiment, the precursor monomers are selected from a thiophene, a pyrrole, an aniline, and a polycyclic aromatic.

### d. Fluorinated Acid Polymers

The fluorinated acid polymer can be any polymer which is fluorinated and has acidic groups with acidic protons. The term includes partially and fully fluorinated materials. In one embodiment, the fluorinated acid polymer is highly fluorinated. The term "highly fluorinated" means that at least 50% of the available hydrogens bonded to a carbon, have been replaced with fluorine. The acidic groups supply an ionizable proton. In one embodiment, the acidic proton has a pKa of less than 3. In one embodiment, the acidic proton has a pKa of less than 0. In one embodiment, the acidic proton has a pKa of less than -5. The acidic group can be attached directly to the polymer backbone, or it can be attached to side chains on the polymer backbone. Examples of acidic groups include, but are not limited to, carboxylic acid groups, sulfonic acid groups, sulfonimide groups, phosphoric acid groups, phosphonic acid groups, and combinations thereof. The acidic groups can all be the same, or the polymer may have more than one type of acidic group.

In one embodiment, the fluorinated acid polymer is water-soluble. In one embodiment, the fluorinated acid polymer is dispersible in water.

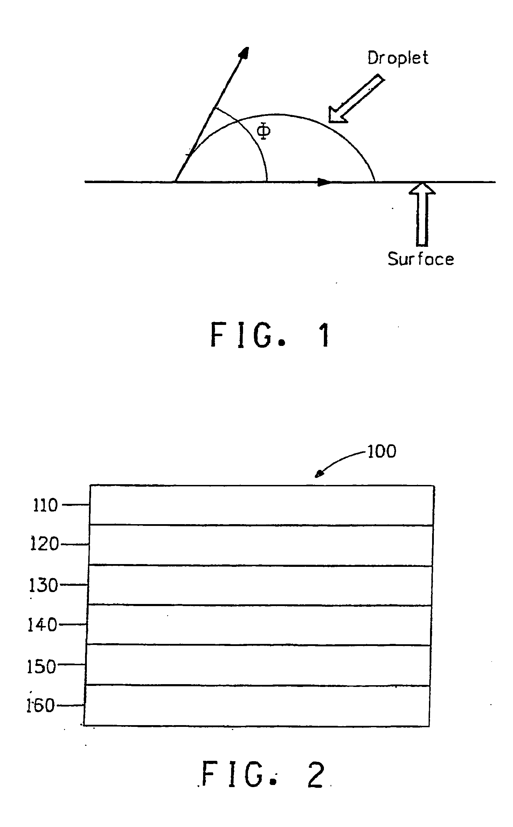

In one embodiment, the fluorinated acid polymer is organic solvent wettable. The term "organic solvent wettable" refers to a material which, when formed into a film, is wettable by organic solvents. In one embodiment, wettable materials form films which are wettable by phenylhexane with a contact angle no greater than 40°. As used herein, the term "contact angle" is intended to mean the angle Φ shown in Figure 1. For a droplet of liquid medium, angle Φ is defined by the intersection of the plane of the surface and a line from the outer edge of the droplet to the surface. Furthermore, angle Φ is measured after the droplet has reached an equilibrium position on the surface after being applied, i.e. "static contact angle". The film of the organic solvent wettable fluorinated polymeric acid is represented as the surface. In one embodiment, the contact angle is no greater than 35°. In one embodiment, the contact angle is no greater than 30°. The methods for measuring contact angles are well known.

In one embodiment, the polymer backbone is fluorinated. Examples of suitable polymeric backbones include, but are not limited to, polyolefins, polyacrylates, polymethacrylates, polyimides, polyamides, polyaramids, polyacrylamides, polystyrenes, and copolymers thereof. In one embodiment, the polymer backbone is highly fluorinated. In one embodiment, the polymer backbone is fully fluorinated.

In one embodiment, the acidic groups are sulfonic acid groups or sulfonimide groups. A sulfonimide group has the formula:

-SO₂-NH-SO₂-R

where R is an alkyl group.

In one embodiment, the acidic groups are on a fluorinated side chain. In one embodiment, the fluorinated side chains are selected from alkyl groups, alkoxy groups, amido groups, ether groups, and combinations thereof.

In one embodiment, the fluorinated acid polymer has a fluorinated olefin backbone, with pendant fluorinated ether sulfonate, fluorinated ester sulfonate, or fluorinated ether sulfonimide groups. In one embodiment, the polymer is a copolymer of 1,1-difluoroethylene and 2-(1,1-difluoro-2-(trifluoromethyl)allyloxy)-1,1,2,2-tetrafluoroethanesulfonic acid. In one embodiment, the polymer is a copolymer of ethylene and 2-(2-(1,2,2-trifluorovinyloxy)-1,1,2,3,3,3-hexafluoropropoxy)-1,1,2,2-tetrafluoroethanesulfonic acid. These copolymers can be made as the corresponding sulfonyl fluoride polymer and then can be converted to the sulfonic acid form.

In one embodiment, the fluorinated acid polymer is homopolymer or copolymer of a fluorinated and partially sulfonated poly(arylene ether sulfone). The copolymer can be a block copolymer. Examples of comonomers include, but are not limited to butadiene, butylene, isobutylene, styrene, and combinations thereof.

In one embodiment, the fluorinated acid polymer is a homopolymer or copolymer of monomers having Formula VII: 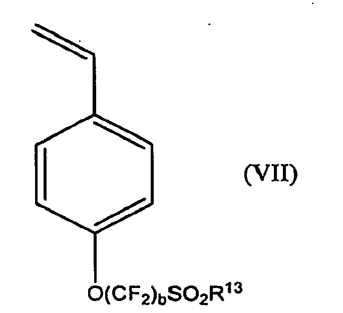 where:
b is an integer from 1 to 5,
R¹³ is OH or NHR¹⁴ and
R¹⁴ is alkyl, fluoroalkyl, sulfonylalkyl, or sulfonylfluoroalkyl.

In one embodiment, the monomer is "SFS" or SFSI" shown below:

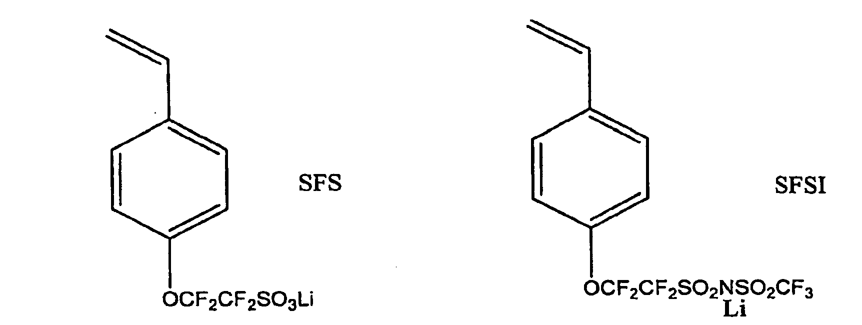

After polymerization, the polymer can be converted to the acid form.

In one embodiment, the fluorinated acid polymer is a homopolymer or copolymer of a trifluorostyrene having acidic groups. In one embodiment, the trifluorostyrene monomer has Formula VIII: 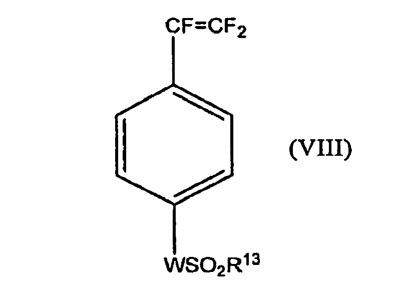 where:
W is selected from (CF₂)_{b}, O(CF₂)_{b}, S(CF₂)_{b}, (CF₂)_{b}O(CF₂)_{b},
b is independently an integer from 1 to 5,
R¹³ is OH or NHR¹⁴, and
R¹⁴ is alkyl, fluoroalkyl, sulfonylalkyl, or sulfonylfluoroalkyl.

In one embodiment, the fluorinated acid polymer is a sulfonimide polymer having Formula IX: 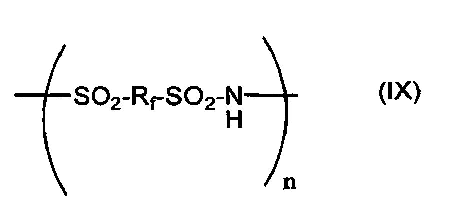 where:
R_{f} is selected from fluorinated alkylene, fluorinated heteroalkylene, fluorinated arylene, and fluorinated heteroarylene; and
n is at least 4.
In one embodiment of Formula IX, R_{f} is a perfluoroalkyl group. In one embodiment, R_{f} is a perfluorobutyl group. In one embodiment, R_{f} contains ether oxygens. In one embodiment n is greater than 10.

In one embodiment, the fluorinated acid polymer comprises a fluorinated polymer backbone and a side chain having Formula X: 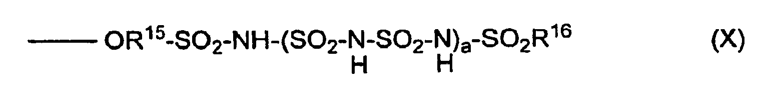 where:
R¹⁵ is a fluorinated alkylene group or a fluorinated heteroalkylene group;
R¹⁶ is a fluorinated alkyl or a fluorinated aryl group; and
a is 0 or an integer from 1 to 4.

In one embodiment, the fluorinated acid polymer has Formula XI: 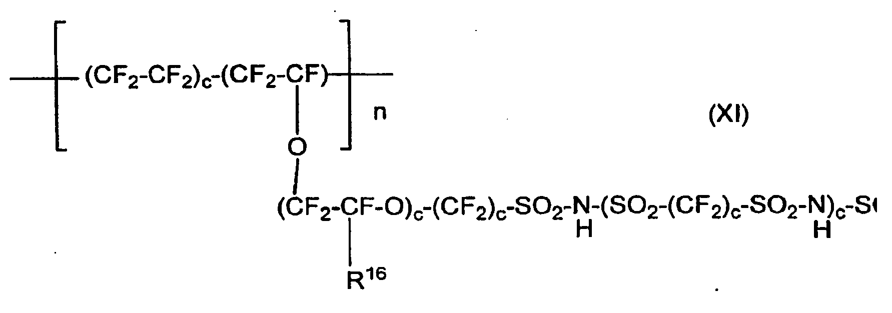 where:
R¹⁶ is a fluorinated alkyl or a fluorinated aryl group;
c is independently 0 or an integer from 1 to 3; and
n is at least 4.

The synthesis of fluorinated acid polymers has been described in, for example, A. Feiring et al., J. Fluorine Chemistry 2000, 105, 129-135; A. Feiring et al., Macromolecules 2000, 33, 9262-9271; D. D. Desmarteau, J. Fluorine Chem. 1995, 72, 203-208; A. J. Appleby et al., J. Electrochem. Soc. 1993, 140(1), 109-111; and Desmarteau, U.S. Patent 5,463,005.

In one embodiment, the fluorinated acid polymer comprises at least one repeat unit derived from an ethylenically unsaturated compound having the structure (XII): 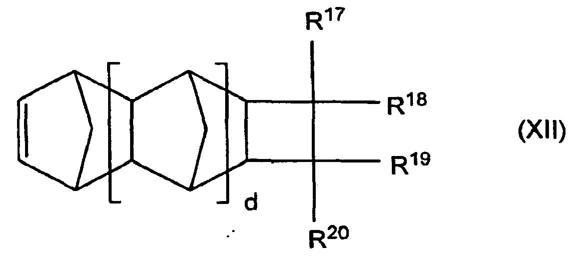
wherein n is 0, 1, or 2;
R¹⁷ to R²⁰ are independently H, halogen, alkyl or alkoxy of 1 to 10 carbon atoms, Y, C(R_{f}')(R_{f}')OR²¹, R⁴Y or OR⁴Y;
Y is COE², SO₂ E², or sulfonimide;
R²¹ is hydrogen or an acid-labile protecting group;
R_{f}' is the same or different at each occurrence and is a fluoroalkyl group of 1 to 10 carbon atoms, or taken together are (CF₂)ₑ where e is 2 to 10;
R⁴ is an alkylene group;
E² is OH, halogen, or OR⁷; and
R⁷ is an alkyl group;
with the proviso that at least one of R¹⁷ to R²⁰ is Y, R⁴Y or OR⁵Y. R⁴, R⁵, and R¹⁷ to R²⁰ may optionally be substituted by halogen or ether oxygen.

Some illustrative, but nonlimiting, examples of representative monomers of structure (XII) and within the scope of the of the materials described herein are presented below (XII-a through XII-e, left to right): 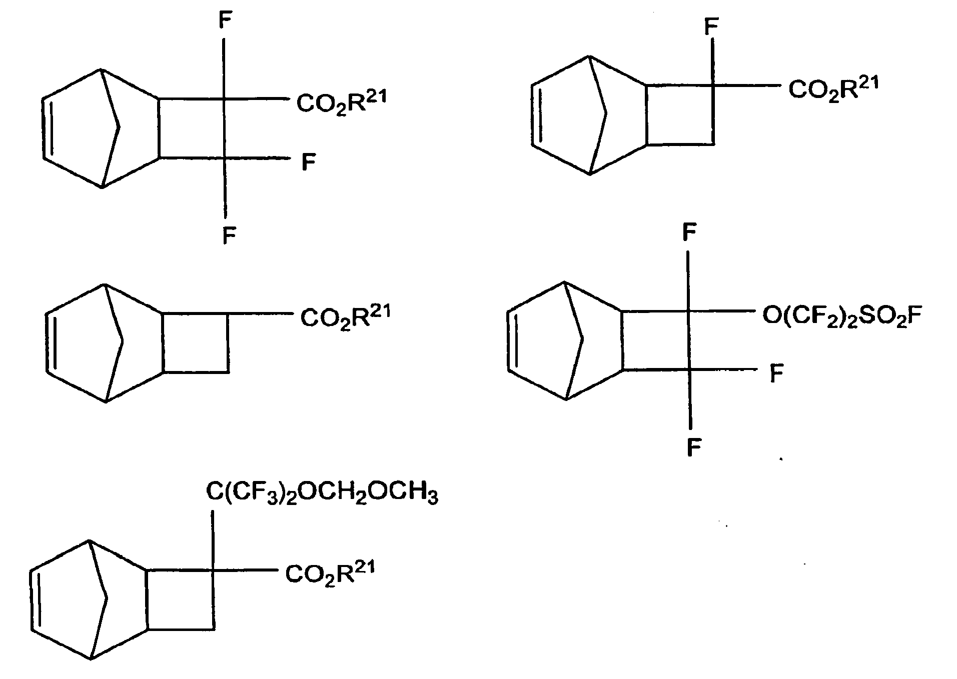 wherein R²¹ is a group capable of forming or rearranging to a tertiary cation, more typically an alkyl group of 1 to 20 carbon atoms, and most typically t-butyl.

Compounds of structure (XII) wherein d = 0, structure (XII-a), may be prepared by cycloaddition reaction of unsaturated compounds of structure (XIII) with quadricyclane (tetracyclo[2.2.1.0^{2,6}0^{3,5}]heptane) as shown in the equation below.

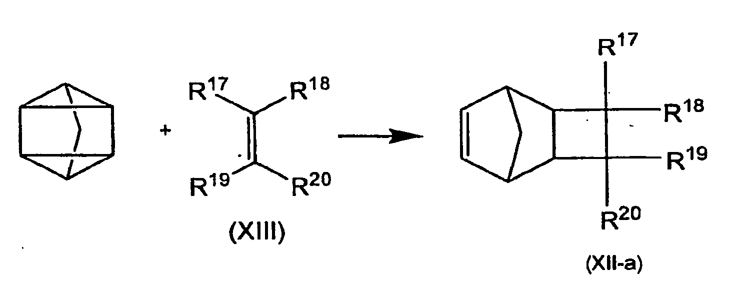

The reaction may be conducted at temperatures ranging from about 0 °C to about 200 °C, more typically from about 30 °C to about 150 °C in the absence or presence of an inert solvent such as diethyl ether: For reactions conducted at or above the boiling point of one or more of the reagents or solvent, a closed reactor is typically used to avoid loss of volatile components. Compounds of structure (XII) with higher values of d (i.e., d = 1 or 2) may be prepared by reaction of compounds of structure (XII) with d = 0 with cyclopentadiene, as is known in the art.

In one embodiment, the fluorinated acid polymer also comprises a repeat unit derived from at least one ethylenically unsaturated compound containing at least one fluorine atom attached to an ethylenically unsaturated carbon. The fluoroolefin comprises 2 to 20 carbon atoms. Representative fluoroolefins include, but are not limited to, tetrafluoroethylene, hexafluoropropylene, chlorotrifluoroethylene, vinylidene fluoride, vinyl fluoride, perfluoro-(2,2-dimethyl-1,3-dioxole), perfluoro-(2-methylene-4-methyl-1,3-dioxolane), CF₂=CFO(CF₂)ₜCF=CF₂, where t is 1 or 2, and R_{f}"OCF=CF₂ wherein R_{f}" is a saturated fluoroalkyl group of from 1 to about ten carbon atoms. In one embodiment, the comonomer is tetrafluoroethylene.

In one embodiment, the fluorinated acid polymer comprises a polymeric backbone having pendant groups comprising siloxane sulfonic acid. In one embodiment, the siloxane pendant groups have the formula below:

-OₐSi(OH)_{b-a}R²²_{3-b}R²³R_{f}SO₃H

wherein:
a is from 1 to b;
b is from 1 to 3;
R²² is a non-hydrolyzable group independently selected from the group consisting of alkyl, aryl, and arylalkyl;
R²³ is a bidentate alkylene radical, which may be substituted by one or more ether oxygen atoms, with the proviso that R²³ has at least two carbon atoms linearly disposed between Si and R_{f}; and
R_{f} is a perfluoralkylene radical, which may be substituted by one or more ether oxygen atoms.
In one embodiment, the fluorinated acid polymer having pendant siloxane groups has a fluorinated backbone. In one embodiment, the backbone is perfluorinated.

In one embodiment, the fluorinated acid polymer has a fluorinated backbone and pendant groups represented by the Formula (XIV)

-O_{g}-[CF(R_{f}²)CF-Oₕ]ᵢ-CF₂CF₂SO₃H (XIV)

wherein R_{f}² is F or a perfluoroalkyl radical having 1-10 carbon atoms either unsubstituted or substituted by one or more ether oxygen atoms, h=0 or 1, i=0 to 3, and g=0 or 1.

In one embodiment, the fluorinated acid polymer has formula (XV) 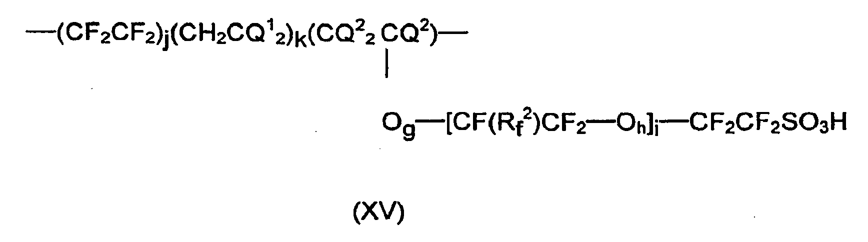 where j ≥ 0, k ≥ 0 and 4 ≤ (j + k) ≤ 199, Q¹ and Q² are F or H, R_{f}² is F or a perfluoroalkyl radical having 1-10 carbon atoms either unsubstituted or substituted by one or more ether oxygen atoms, h=0 or 1, i=0 to 3, g=0 or 1. In one embodiment R_{f}² is -CF₃, g=1, h=1, and i=1. In

one embodiment the pendant group is present at a concentration of 3-10 mol-%.

In one embodiment, Q¹ is H, k ≥ 0, and Q² is F, which may be synthesized according to the teachings of Connolly et al., U.S. Patent 3,282,875. In another preferred embodiment, Q¹ is H, Q² is H, g=0, R_{f}² is F, h=1, and I=1, which may be synthesized according to the teachings of co-pending application serial number 60/105,662. Still other embodiments may be synthesized according to the various teachings in Drysdale et al., WO 9831716(A1), and co-pending US applications Choi et al, WO 99/52954(A1), and 60/176,881.

In one embodiment, the fluorinated acid polymer is a colloid-forming polymeric acid. As used herein, the term "colloid-forming" refers to materials which are insoluble in water, and form colloids when dispersed into an aqueous medium. The colloid-forming polymeric acids typically have a molecular weight in the range of about 10,000 to about 4,000,000. In one embodiment, the polymeric acids have a molecular weight of about 100,000 to about 2,000,000. Colloid particle size typically ranges from 2 nanometers (nm) to about 140 nm. In one embodiment, the colloids have a particle size of 2 nm to about 30 nm. Any colloid-forming polymeric material having acidic protons can be used. In one embodiment, the colloid-forming fluorinated polymeric acid has acidic groups selected from carboxylic groups, sulfonic acid groups, and sulfonimide groups. In one embodiment, the colloid-forming fluorinated polymeric acid is a polymeric sulfonic acid. In one embodiment, the colloid-forming polymeric sulfonic acid is perfluorinated. In one embodiment, the colloid-forming polymeric sulfonic acid is a perfluoroalkylenesulfonic acid.

In one embodiment, the colloid-forming polymeric acid is a highly-fluorinated sulfonic acid polymer ("FSA polymer"). "Highly fluorinated" means that at least about 50% of the total number of halogen and hydrogen atoms in the polymer are fluorine atoms, an in one embodiment at least about 75%, and in another embodiment at least about 90%. In one embodiment, the polymer is perfluorinated. The term "sulfonate functional group" refers to either to sulfonic acid groups or salts of sulfonic acid groups, and in one embodiment alkali metal or ammonium salts. The functional group is represented by the formula -SO₃E⁵ where E⁵ is a cation, also known as a "counterion". E⁵ may be H, Li, Na, K or N(R₁)(R₂)(R₃)(R₄), and R₁, R₂, R₃, and R₄ are the same or different and are and in one embodiment H, CH₃ or C₂H₅. In another embodiment, E⁵ is H, in which case the polymer is said to be in the "acid form". E⁵ may also be multivalent, as represented by such ions as Ca⁺⁺, and Al⁺⁺⁺. It is clear to the skilled artisan that in the case of multivalent counterions, represented generally as M^{x+}, the number of sulfonate functional groups per counterion will be equal to the valence "x".

In one embodiment, the FSA polymer comprises a polymer backbone with recurring side chains attached to the backbone, the side chains carrying cation exchange groups. Polymers include homopolymers or copolymers of two or more monomers. Copolymers are typically formed from a nonfunctional monomer and a second monomer carrying the cation exchange group or its precursor, e.g., a sulfonyl fluoride group (-SO₂F), which can be subsequently hydrolyzed to a sulfonate functional group. For example, copolymers of a first fluorinated vinyl monomer together with a second fluorinated vinyl monomer having a sulfonyl fluoride group (-SO₂F) can be used. Possible first monomers include tetrafluoroethylene (TFE), hexafluoropropylene, vinyl fluoride, vinylidine fluoride, trifluoroethylene, chlorotrifluoroethylene, perfluoro(alkyl vinyl ether), and combinations thereof. TFE is a preferred first monomer.

In other embodiments, possible second monomers include fluorinated vinyl ethers with sulfonate functional groups or precursor groups which can provide the desired side chain in the polymer. Additional monomers, including ethylene, propylene, and R-CH=CH₂ where R is a perfluorinated alkyl group of 1 to 10 carbon atoms, can be incorporated into these polymers if desired. The polymers may be of the type referred to herein as random copolymers, that is copolymers made by polymerization in which the relative concentrations of the comonomers are kept as constant as possible, so that the distribution of the monomer units along the polymer chain is in accordance with their relative concentrations and relative reactivities. Less random copolymers, made by varying relative concentrations of monomers in the course of the polymerization, may also be used. Polymers of the type called block copolymers, such as that disclosed in European Patent Application No. 1 026 152 A1, may also be used.

In one embodiment, FSA polymers for use in the present compositionsinclude a highly fluorinated, and in one embodiment perfluorinated, carbon backbone and side chains represented by the formula

-(O-CF₂CFR_{f}³)ₐ-O-CF₂CFR_{f}⁴SO₃E⁵

wherein R_{f}³ and R_{f}⁴ are independently selected from F, Cl or a perfluorinated alkyl group having 1 to 10 carbon atoms, a = 0, 1 or 2, and E⁵ is H, Li, Na, K or N(R1)(R2)(R3)(R4) and R1, R2, R3, and R4 are the same or different and are and in one embodiment H, CH₃ or C₂H₅. In another embodiment E⁵ is H. As stated above, E⁵ may also be multivalent.

In one embodiment, the FSA polymers include, for example, polymers disclosed in U.S. Patent No. 3,282,875 and in U.S. Patent Nos. 4,358,545 and 4,940,525. An example of preferred FSA polymer comprises a perfluorocarbon backbone and the side chain represented by the formula

-O-CF₂CF(CF₃)-O-CF₂CF₂SO₃E⁵

where X is as defined above. FSA polymers of this type are disclosed in U.S. Patent No. 3,282,875 and can be made by copolymerization of tetrafluoroethylene (TFE) and the perfluorinated vinyl ether CF₂=CF-O-CF₂CF(CF₃)-O-CF₂CF₂SO₂F, perfluoro(3,6-dioxa-4-methyl-7-octenesulfonyl fluoride) (PDMOF), followed by conversion to sulfonate groups by hydrolysis of the sulfonyl fluoride groups and ion exchanged as necessary to convert them to the desired ionic form. An example of a polymer of the type disclosed in U.S. Patent Nos. 4,358,545 and 4,940,525 has the side chain -O-CF₂CF₂SO₃E⁵, wherein E⁵ is as defined above. This polymer can be made by copolymerization of tetrafluoroethylene (TFE) and the perfluorinated vinyl ether CF₂=CF-O-CF₂CF₂SO₂F, perfluoro(3-oxa-4-pentenesulfonyl fluoride) (POPF), followed by hydrolysis and further ion exchange as necessary.

In one embodiment, the FSA polymers for use in the present compositions typically have an ion exchange ratio of less than about 33. In this application, "ion exchange ratio" or "IXR" is defined as number of carbon atoms in the polymer backbone in relation to the cation exchange groups. Within the range of less than about 33, IXR can be varied as desired for the particular application. In one embodiment, the IXR is about 3 to about 33, and in another embodiment about 8 to about 23.

The cation exchange capacity of a polymer is often expressed in terms of equivalent weight (EW). For the purposes of this application, equivalent weight (EW) is defined to be the weight of the polymer in acid form required to neutralize one equivalent of sodium hydroxide. In the case of a sulfonate polymer where the polymer has a perfluorocarbon backbone and the side chain is -O-CF₂-CF(CF₃)-O-CF₂-CF₂-SO₃H (or a salt thereof), the equivalent weight range which corresponds to an IXR of about 8 to about 23 is about 750 EW to about 1500 EW. IXR for this polymer can be related to equivalent weight using the formula: 50 IXR + 344 = EW. While the same IXR range is used for sulfonate polymers disclosed in U.S. Patent Nos. 4,358,545 and 4,940,525, e.g., the polymer having the side chain -O-CF₂CF₂SO₃H (or a salt thereof), the equivalent weight is somewhat lower because of the lower molecular weight of the monomer unit containing a cation exchange group. For the preferred IXR range of about 8 to about 23, the corresponding equivalent weight range is about 575 EW to about 1325 EW. IXR for this polymer can be related to equivalent weight using the formula: 50 IXR + 178 = EW.

The FSA polymers can be prepared as colloidal aqueous dispersions. They may also be in the form of dispersions in other media, examples of which include, but are not limited to, alcohol, water-soluble ethers, such as tetrahydrofuran, mixtures of water-soluble ethers, and combinations thereof. In making the dispersions, the polymer can be used in acid form. U.S. Patent Nos. 4,433,082, 6,150,426 and WO 03/006537 disclose methods for making of aqueous alcoholic dispersions. After the dispersion is made, concentration and the dispersing liquid composition can be adjusted by methods known in the art.

Aqueous dispersions of the colloid-forming polymeric acids, including FSA polymers, typically have particle sizes as small as possible and an EW as small as possible, so long as a stable colloid is formed.

Aqueous dispersions of FSA polymer are available commercially as Nation® dispersions, from E. I. du Pont de Nemours and Company (Wilmington, DE).

Some of the polymers described hereinabove may be formed in non-acid form, e.g., as salts, esters, or sulfonyl fluorides. They will be converted to the acid form for the preparation of conductive compositions, described below.

### e. Preparation of conductive polymer compositions with fluorinated acid polymers

The electrically conductive polymer composition is prepared by (i) polymerizing the precursor monomers in the presence of the fluorinated acid polymer; or (ii) first forming the intrinsically conductive copolymer and combining it with the fluorinated acid polymer.

### (i) Polymerizing precursor monomers in the presence of the fluorinated acid polymer

In one embodiment, the electrically conductive polymer composition is formed by the oxidative polymerization of the precursor monomers in the presence of the fluorinated acid polymer. In one embodiment, the precursor monomers comprises two or more conductive precursor monomers. In one embodiment, the monomers comprise an intermediate precursor monomer having the structure A-B-C, where A and C represent conductive precursor monomers, which can be the same or different, and B represents a non-conductive precursor monomer. In one embodiment, the intermediate precursor monomer is polymerized with one or more conductive precursor monomers.

In one embodiment, the oxidative polymerization is carried out in a homogeneous aqueous solution. In another embodiment, the oxidative polymerization is carried out in an emulsion of water and an organic solvent. In general, some water is present in order to obtain adequate solubility of the oxidizing agent and/or catalyst. Oxidizing agents such as ammonium persulfate, sodium persulfate, potassium persulfate, and the like, can be used. A catalyst, such as ferric chloride, or ferric sulfate may also be present. The resulting polymerized product will be a solution, dispersion, or emulsion of the conductive polymer in association with the fluorinated acid polymer. In one embodiment, the intrinsically conductive polymer is positively charged, and the charges are balanced by the fluorinated acid polymer anion.

In one embodiment, the method of making an aqueous dispersion of the conductive polymer composition includes forming a reaction mixture by combining water, precursor monomer, at least one fluorinated acid polymer, and an oxidizing agent, in any order, provided that at least a portion of the fluorinated acid polymer is present when at least one of the precursor monomer and the oxidizing agent is added.

In one embodiment, the method of making the conductive polymer composition comprises:
(a) providing an aqueous solution or dispersion of a fluorinated acid polymer;
(b) adding an oxidizer to the solutions or dispersion of step (a); and
(c) adding precursor monomer to the mixture of step (b).

In another embodiment, the precursor monomer is added to the aqueous solution or dispersion of the fluorinated acid polymer prior to adding the oxidizer. Step (b) above, which is adding oxidizing agent, is then carried out.

In another embodiment, a mixture of water and the precursor monomer is formed, in a concentration typically in the range of about 0.5% by weight to about 4.0% by weight total precursor monomer. This precursor monomer mixture is added to the aqueous solution or dispersion of the fluorinated acid polymer, and steps (b) above which is adding oxidizing agent is carried out.

In another embodiment, the aqueous polymerization mixture may include a polymerization catalyst, such as ferric sulfate, ferric chloride, and the like. The catalyst is added before the last step. In another embodiment, a catalyst is added together with an oxidizing agent.

In one embodiment, the polymerization is carried out in the presence of co-dispersing liquids which are miscible with water. Examples of suitable co-dispersing liquids include, but are not limited to ethers, alcohols, alcohol ethers, cyclic ethers, ketones, nitriles, sulfoxides, amides, and combinations thereof. In one embodiment, the co-dispersing liquid is an alcohol. In one embodiment, the co-dispersing liquid is an organic solvent selected from n-propanol, isopropanol, t-butanol, dimethylacetamide, dimethylformamide, N-methylpyrrolidone, and mixtures thereof. In general, the amount of co-dispersing liquid should be less than about 60% by volume. In one embodiment, the amount of co-dispersing liquid is less than about 30% by volume. In one embodiment, the amount of co-dispersing liquid is between 5 and 50% by volume. The use of a co-dispersing liquid in the polymerization significantly reduces particle size and improves filterability of the dispersions. In addition, buffer materials obtained by this process show an increased viscosity and films prepared from these dispersions are of high quality.

The co-dispersing liquid can be added to the reaction mixture at any point in the process.

In one embodiment, the polymerization is carried out in the presence of a co-acid which is a Brønsted acid. The acid can be an inorganic acid, such as HCl, sulfuric acid, and the like, or an organic acid, such as acetic acid or p-toluenesulfonic acid. Alternatively, the acid can be a water soluble polymeric acid such as poly(styrenesulfonic acid), poly(2-acrylamido-2-methyl-1-propanesulfonic acid, or the like, or a second fluorinated acid polymer, as described above. Combinations of acids can be used.

The co-acid can be added to the reaction mixture at any point in the process prior to the addition of either the oxidizer or the precursor monomer, whichever is added last. In one embodiment, the co-acid is added before both the precursor monomers and the fluorinated acid polymer, and the oxidizer is added last. In one embodiment the co-acid is added prior to the addition of the precursor monomers, followed by the addition of the fluorinated acid polymer, and the oxidizer is added last.

In one embodiment, the polymerization is carried out in the presence of both a co-dispersing liquid and a co-acid.

In one embodiment, a reaction vessel is charged first with a mixture of water, alcohol co-dispersing agent, and inorganic co-acid. To this is added, in order, the precursor monomers, an aqueous solution or dispersion of fluorinated acid polymer, and an oxidizer. The oxidizer is added slowly and dropwise to prevent the formation of localized areas of high ion concentration which can destabilize the mixture. The mixture is stirred and the reaction is then allowed to proceed at a controlled temperature. When polymerization is completed, the reaction mixture is treated with a strong acid cation resin, stirred and filtered; and then treated with a base anion exchange resin, stirred and filtered. Alternative orders of addition can be used, as discussed above.

In the method of making the conductive polymer composition, the molar ratio of oxidizer to total precursor monomer is generally in the range of 0.1 to 2.0; and in one embodiment is 0.4 to 1.5. The molar ratio of fluorinated acid polymer to total precursor monomer is generally in the range of 0.2 to 5. In one embodiment, the ratio is in the range of 1 to 4. The overall solid content is generally in the range of about 1.0% to 10% in weight percentage; and in one embodiment of about 2% to 4.5%. The reaction temperature is generally in the range of about 4°C to 50°C; in one embodiment about 20°C to 35°C. The molar ratio of optional co-acid to precursor monomer is about 0.05 to 4. The addition time of the oxidizer influences particle size and viscosity. Thus, the particle size can be reduced by slowing down the addition speed. In parallel, the viscosity is increased by slowing down the addition speed. The reaction time is generally in the range of about 1 to about 30 hours.

### (ii) Combining intrinsically conductive polymers with fluorinated acid polymers

In one embodiment, the intrinsically conductive polymers are formed separately from the fluorinated acid polymer. In one embodiment, the polymers are prepared by oxidatively polymerizing the corresponding monomers in aqueous solution. In one embodiment, the oxidative polymerization is carried out in the presence of a water soluble acid. In one embodiment, the acid is a water-soluble non-flurorinated polymeric acid. In one embodiment, the acid is a non-fluorinated polymeric sulfonic acid. Some non-limiting examples of the acids are poly(styrenesulfonic acid) ("PSSA"), poly(2-acrylamido-2-methyl-1-propanesulfonic acid) ("PAAMPSA"), and mixtures thereof. Where the oxidative polymerization results in a polymer that has positive charge, the acid anion provides the counterion for the conductive polymer. The oxidative polymerization is carried out using an oxidizing agent such as ammonium persulfate, sodium persulfate, and mixtures thereof.

The electrically conductive polymer composition is prepared by blending the intrinsically conductive polymer with the fluorinated acid polymer. This can be accomplished by adding an aqueous dispersion of the intrinsically conductive polymer to a dispersion or solution of the polymeric acid. In one embodiment, the composition is further treated using sonication or microfluidization to ensure mixing of the components.

In one embodiment, one or both of the intrinsically conductive polymer and fluorinated acid polymer are isolated in solid form. The solid material can be redispersed in water or in an aqueous solution or dispersion of the other component. For example, intrinsically conductive polymer solids can be dispersed in an aqueous solution or dispersion of a fluorinated acid polymer.

### (iii) pH adjustment

As synthesized, the aqueous dispersions of the conductive polymer composition generally have a very low pH. In one embodiment, the pH is adjusted to higher values, without adversely affecting the properties in devices. In one embodiment, the pH of the dispersion is adjusted to about 1.5 to about 4. In one embodiment, the pH is adjusted to between 3 and 4.It has been found that the pH can be adjusted using known techniques, for example, ion exchange or by titration with an aqueous basic solution.

In one embodiment, after completion of the polymerization reaction, the as-synthesized aqueous dispersion is contacted with at least one ion exchange resin under conditions suitable to remove decomposed species, side reaction products, and unreacted monomers, and to adjust pH, thus producing a stable, aqueous dispersion with a desired pH. In one embodiment, the as-synthesized aqueous dispersion is contacted with a first ion exchange resin and a second ion exchange resin, in any order. The as-synthesized aqueous dispersion can be treated with both the first and second ion exchange resins simultaneously, or it can be treated sequentially with one and then the other.

Ion exchange is a reversible chemical reaction wherein an ion in a fluid medium (such as an aqueous dispersion) is exchanged for a similarly charged ion attached to an immobile solid particle that is insoluble in the fluid medium. The term "ion exchange resin" is used herein to refer to all such substances. The resin is rendered insoluble due to the crosslinked nature of the polymeric support to which the ion exchanging groups are attached. Ion exchange resins are classified as cation exchangers or anion exchangers. Cation exchangers have positively charged mobile ions available for exchange, typically protons or metal ions such as sodium ions. Anion exchangers have exchangeable ions which are negatively charged, typically hydroxide ions.

In one embodiment, the first ion exchange resin is a cation, acid exchange resin which can be in protonic or metal ion, typically sodium ion, form. The second ion exchange resin is a basic, anion exchange resin. Both acidic, cation including proton exchange resins and basic, anion exchange resins are contemplated for use in the practice of the processes herein. In one embodiment, the acidic, cation exchange resin is an inorganic acid, cation exchange resin, such as a sulfonic acid cation exchange resin. Sulfonic acid cation exchange resins contemplated for use in the practice of the processes herein include, for example, sulfonated styrene-divinylbenzene copolymers, sulfonated crosslinked styrene polymers, phenol-formaldehyde-sulfonic acid resins, benzene-formaldehyde-sulfonic acid resins, and mixtures thereof. In another embodiment, the acidic, cation exchange resin is an organic acid, cation exchange resin, such as carboxylic acid, acrylic or phosphorous cation exchange resin. In addition, mixtures of different cation exchange resins can be used.

In another embodiment, the basic, anionic exchange resin is a tertiary amine anion exchange resin. Tertiary amine anion exchange resins contemplated for use in the practice of the processes herein include, for example, tertiary-aminated styrene-divinylbenzene copolymers, tertiary-aminated crosslinked styrene polymers, tertiary-aminated phenol-formaldehyde resins, tertiary-aminated benzene-formaldehyde resins, and mixtures thereof. In a further embodiment, the basic, anionic exchange resin is a quaternary amine anion exchange resin, or mixtures of these and other exchange resins.

The first and second ion exchange resins may contact the as-synthesized aqueous dispersion either simultaneously, or consecutively. For example, in one embodiment both resins are added simultaneously to an as-synthesized aqueous dispersion of an electrically conducting polymer, and allowed to remain in contact with the dispersion for at least about 1 hour, e.g., about 2 hours to about 20 hours. The ion exchange resins can then be removed from the dispersion by filtration. The size of the filter is chosen so that the relatively large ion exchange resin particles will be removed while the smaller dispersion particles will pass through. Without wishing to be bound by theory, it is believed that the ion exchange resins quench polymerization and effectively remove ionic and non-ionic impurities and most of unreacted monomer from the as-synthesized aqueous dispersion. Moreover, the basic, anion exchange and/or acidic, cation exchange resins renders the acidic sites more basic, resulting in increased pH of the dispersion. In general, about one to five grams of ion exchange resin is used per gram of conductive polymer composition.

In many cases, the basic ion exchange resin can be used to adjust the pH to the desired level. In some cases, the pH can be further adjusted with an aqueous basic solution such as a solution of sodium hydroxide, ammonium hydroxide, tetra-methylammonium hydroxide, or the like.

### 3. Second and Third Layers

The exact composition of the second and third layers can depend upon the intended use of the electronic device.

The second layer is one having a surface energy that is greater than the surface energy of the first layer. In some embodiments, the second layer will have a surface energy such that it is wettable by phenylhexane with a contact angle less than 40°.

In one embodiment, the second layer comprises a hole transport material. The hole transport material may be selected from the group consisting of a polymer, a non-polymeric material, and combinations thereof. Specific examples of such materials are given hereinbelow.

In one embodiment, the third layer comprises a photoactive material. In one embodiment the third layer comprises an electroluminescent material. Specific examples of such materials are given hereinbelow.

### 4. Process

The first layer is formed having a first surface energy.

In one embodiment, the first layer is formed on a substrate by liquid deposition from a liquid composition. The term "substrate" is intended to mean a base material that can be either rigid or flexible and may be include one or more layers of one or more materials. Substrate materials can include, but are not limited to, glass, polymer, metal or ceramic materials or combinations thereof. The substrate may or may not include electronic components, circuits, conductive members, or layers of other materials.

Any known liquid deposition technique can be used, including continuous and discontinuous techniques. Continuous liquid deposition techniques, include but are not limited to, spin coating, gravure coating, curtain coating, dip coating, slot-die coating, spray coating, and continuous nozzle coating. Discontinuous liquid deposition techniques include, but are not limited to, ink jet printing, gravure printing, flexographic printing and screen printing.

In one embodiment, the first layer is formed by liquid deposition from a liquid composition having a pH greater than 2. In one embodiment, the pH is greater than 4. In one embodiment, the pH is greater than 6.

The thickness of the first layer can be as great as desired for the intended use. In one embodiment, the first layer has a thickness in the range of 100 nm to 200 microns. In one embodiment, the first layer has a thickness in the range of 50 -500 nm. In one embodiment, the first layer has a thickness less than 50nm. In one embodiment, the first layer has a thickness less than 10nm. In one embodiment, the first layer has a thickness that is greater than the thickness of the second layer.

In one embodiment, the first layer is applied over a liquid containment structure. It may be desired to use a structure that is inadequate for complete containment, but that still allows adjustment of thickness uniformity of the printed layer. In this case it may be desirable to control wetting onto the thickness-tuning structure, providing both containment and uniformity. It is then desirable to be able to modulate the contact angle of the emissive ink. Most surface treatments used for containment (e.g., CF4 plasma) do not provide this level of control.

In one embodiment, the first layer is applied over a so-called bank structure. Bank structures are typically formed from photoresists, organic materials (e.g., polyimides), or inorganic materials (oxides, nitrides, and the like). Bank structures may be used for containing the first layer in its liquid form, preventing color mixing; and/or for improving the thickness uniformity of the first layer as it is dried from its liquid form; and/or for protecting underlying features from contact by the liquid. Such underlying features can include conductive traces, gaps between conductive traces, thin film transistors, electrodes, and the like.

The second layer is formed over the first layer, and has a surface energy which is greater than the first surface energy.

In one embodiment, the second layer is formed directly on the first layer by liquid deposition from a liquid composition.

In one embodiment, the second layer is formed by vapor deposition onto the first layer. Any vapor deposition technique can be used, including sputtering, thermal evaporation, chemical vapor deposition and the like. Chemical vapor deposition may be performed as a plasma-enhanced chemical vapor deposition ("PECVD") or metal organic chemical vapor deposition ("MOCVD"). Physical vapor deposition can include all forms of sputtering, including ion beam sputtering, as well as e-beam evaporation and resistance evaporation. Specific forms of physical vapor deposition include rf magnetron sputtering and inductively-coupled plasma physical vapor deposition ("IMP-PVD"). These deposition techniques are well known within the semiconductor fabrication arts.

The thickness of the second layer can be a little as a single monolayer. In one embodiment, the thickness is in the range of 100 nm to 200 microns. In one embodiment, the thickness is less than 100 nm. In one embodiment, the thickness is less than 10 nm. In one embodiment, the thickness is less than 1 nm.

After the second layer is formed, selected portions are removed, resulting in uncovered areas of the first layer.

In one embodiment, selected portions of the second layer are removed using photoresist technology. The use of photoresist technology is well known in the art. A photosensitive material, the photoresist, is deposited over the entire surface of the second layer. The photoresist is exposed to activating radiation patternwise. The photoresist is then developed to remove either the exposed or unexposed portions. In some embodiments, development is carried out by treatment with a solvent to remove areas of the photoresist which are more soluble, swellable or dispersible. When areas of the photoresist are removed, this results areas of the second layer which are uncovered. These areas of the second layer are then removed by a controlled etching step. In some embodiments, the etching can be accomplished by using a solvent which will remove the second layer but not the underlying first layer. In some embodiments, the etching can be accomplished by treatment with a plasma.. The remaining photoresist is then removed, usually by treatment with a solvent.

In one embodiment, selected portions of the second layer are removed by patternwise treatment with radiation. The terms "radiating" and "radiation" are intended to mean the addition of energy in any form, including heat in any form, the entire electromagnetic spectrum, or subatomic particles, regardless of whether such radiation is in the form of rays, waves, or particles. In one embodiment, the second layer comprises a thermally fugitive material and portions are removed by treatment with an infrared radiation. In some embodiments, the infrared radiation is applied by a laser. Infrared diode lasers are well known and can be used to expose the second layer in a pattern. In one embodiment, portions of the second layer can be removed by exposure to UV radiation.

In one embodiment, selected portions of the second layer are removed by laser ablation. In one embodiment, an excimer laser is used.

In one embodiment, selected portions of the second layer are removed by dry etching. As used herein, the term "dry etching" means etching that is performed using gas(es). The dry etching may be performed using ionized gas(es) or without using ionized gas(es). In one embodiment, at least one oxygen-containing gas is in the gas used. Exemplary oxygen-containing gases include O₂, COF₂, CO, O₃, NO, N₂O, and mixtures thereof. At least one halogen-containing gas may also be used in combination with at least one oxygen-containing gas. The halogen-containing gas can include any one or more of a fluorine-containing gas, a chlorine-containing gas, a bromine-containing gas, or an iodine-containing gas and mixtures thereof.

The third layer is then applied over the uncovered areas of the first layer. The third layer can be applied by any deposition technique. In one embodiment, the third layer is applied by a liquid deposition technique. In some embodiments, a liquid composition comprising a third material dissolved or dispersed in a liquid medium is applied over the patterned second layer, and dried to form the third layer. The liquid composition is chosen to have a surface energy that is greater than the surface energy of the first layer, but approximately the same as or less than the surface energy of the second layer. The liquid composition will wet the second layer in the areas remaining, but will be repelled from the first layer in the areas where the second layer has been removed. The liquid may spread onto the area of the first layer, but it will de-wet. Thus, a contained third layer is formed.

In one embodiment, the third layer is applied using a continuous liquid deposition technique. In one embodiment, the third layer is applied using a discontinuous liquid deposition technique.

The thickness of the third layer can be as great as desired for the intended use. In one embodiment, the third layer has a thickness in the range of 100 nm to 200 microns. In one embodiment, the third layer has a thickness in the range of 50 -500 nm. In one embodiment, the third layer has a thickness less than 50nm. In one embodiment, the third layer has a thickness less than 10nm.

### 5. Electronic Device

In another embodiment, there are provided electronic devices in which at least some of the layers are made using the new process described herein. The term "electronic device" is intended to mean a device including one or more organic semiconductor layers or materials. An electronic device includes, but is not limited to: (1) a device that converts electrical energy into radiation (e.g., a light-emitting diode, light emitting diode display, diode laser, or lighting panel), (2) a device that detects a signal using an electronic process (e.g., a photodetector, a photoconductive cell, a photoresistor, a photoswitch, a phototransistor, a phototube, an infrared ("IR") detector, or a biosensors), (3) a device that converts radiation into electrical energy (e.g., a photovoltaic device or solar cell), (4) a device that includes one or more electronic components that include one or more organic semiconductor layers (e.g., a transistor or diode), or any combination of devices in items (1) through (4).

The process will be further described in terms of its application in an organic light-emitting device ("OLED") as an exemplary electronic device, although it is not limited to such application.

An example of an OLED is given in FIG. 2. The OLED includes at least three organic active layers positioned between two electrical contact layers. The electronic device 100 includes one or more layers 120 and 130 to facilitate the injection of holes from the anode layer 110 into the photoactive layer 140. In general, when two layers are present, the layer 120 adjacent the anode is called the hole injection layer or buffer layer. The layer 130 adjacent to the photoactive layer is called the hole transport layer. An optional electron transport layer 150 is located between the photoactive layer 140 and a cathode layer 160. Depending on the application of the device 100, the photoactive layer 140 can be a light-emitting layer that is activated by an applied voltage (such as in a light-emitting diode or light-emitting electrochemical cell), a layer of material that responds to radiant energy and generates a signal with or without an applied bias voltage (such as in a photodetector). The device is not limited with respect to system, driving method, and utility mode.

For multicolor devices, the photoactive layer 140 is made up different areas of at least three different colors. The areas of different color can be formed by printing the separate colored areas. Alternatively, it can be accomplished by forming an overall layer and doping different areas of the layer with emissive materials with different colors. Such a process has been described in, for example, published U.S. patent application 2004-0094768.

In some embodiments, the new process described herein can be used to apply a hole injection layer (first layer), followed by a hole transport layer (second layer), followed by a photoactive layer (third layer). The patterning of the hole transport layer (second layer) is used to contain the placement of the photoactive layer, so that the different colored sub-pixel layers do not overlap or mix.

In one embodiment, the anode 110 is formed in a pattern of parallel stripes. The hole injection layer 120 (first layer) and the hole transport layer 130 (second layer) are formed as continuous layers over the anode 110. Areas of the hole transport layer 120 are removed in a pattern such that at least the areas where it is desired to deposit the photoactive layer 140 (third layer) remain covered. The liquid composition for depositing the photoactive layer 140 (third layer) will be able to wet higher surface energy hole transport material, but will not spread and remain in the area where the lower surface energy hole injection layer 120 has been uncovered.

The layers in the device can be made of any materials which are known to be useful in such layers. The device may include a support or substrate (not shown) that can be adjacent to the anode layer 110 or the cathode layer 150. Most frequently, the support is adjacent the anode layer 110. The support can be flexible or rigid, organic or inorganic. Generally, glass or flexible organic films are used as a support. The anode layer 110 is an electrode that is more efficient for injecting holes compared to the cathode layer 160. The anode can include materials containing a metal, mixed metal, alloy, metal oxide or mixed oxide. Suitable materials include the mixed oxides of the Group 2 elements (i.e., Be, Mg, Ca, Sr, Ba, Ra), the Group 11 elements, the elements in Groups 4, 5, and 6, and the Group 8-10 transition elements. If the anode layer 110 is to be light transmitting, mixed oxides of Groups 12, 13 and 14 elements, such as indium-tin-oxide, may be used. As used herein, the phrase "mixed oxide" refers to oxides having two or more different cations selected from the Group 2 elements or the Groups 12, 13, or 14 elements. Some non-limiting, specific examples of materials for anode layer 110 include, but are not limited to, indium-tin-oxide ("ITO"), aluminum-tin-oxide, gold, silver, copper, and nickel. The anode may also comprise an organic material such as polyaniline, polythiophene, or polypyrrole.

The anode layer 110 may be formed by a chemical or physical vapor deposition process or spin-cast process. Chemical vapor deposition may be performed as a plasma-enhanced chemical vapor deposition ("PECVD") or metal organic chemical vapor deposition ("MOCVD"). Physical vapor deposition can include all forms of sputtering, including ion beam sputtering, as well as e-beam evaporation and resistance evaporation. Specific forms of physical vapor deposition include rf magnetron sputtering and inductively-coupled plasma physical vapor deposition ("IMP-PVD"). These deposition techniques are well known within the semiconductor fabrication arts.

Usually, the anode layer 110 is patterned during a lithographic operation. The pattern may vary as desired. The layers can be formed in a pattern by, for example, positioning a patterned mask or resist on the first flexible composite barrier structure prior to applying the first electrical contact layer material. Alternatively, the layers can be applied as an overall layer (also called blanket deposit) and subsequently patterned using, for example, a patterned resist layer and wet chemical or dry etching techniques. Other processes for patterning that are well known in the art can also be used. When the electronic devices are located within an array, the anode layer 110 typically is formed into substantially parallel strips having lengths that extend in substantially the same direction.

The hole injection layer 120 functions to facilitate injection of holes into the photoactive layer and to smoothen the anode surface to prevent shorts in the device. This layer is made from a composition comprising an electrically conductive material and a fluorinated acid polymer, as described hereinabove. In one embodiment, the hole injection layer 120 is made from a dispersion of a conducting polymer and a colloid-forming polymeric acid. Such materials have been described in, for example, published U.S. patent applications 2004-0102577 and 2004-0127637.

The hole injection layer 120 can be applied by any deposition technique. In one embodiment, the buffer layer is applied by a solution deposition method, as described above. In one embodiment, the buffer layer is applied by a continuous solution deposition method.

Examples of hole transport materials for optional layer 130 have been summarized for example, in Kirk-Othmer Encyclopedia of Chemical Technology, Fourth Edition, Vol. 18, p. 837-860, 1996, by Y. Wang. Both hole transporting molecules and polymers can be used. Commonly used hole transporting molecules include, but are not limited to: 4,4',4"-tris(N,N-diphenyl-amino)-triphenylamine (TDATA); 4,4',4"-tris(N-3-methylphenyl-N-phenyl-amino)-triphenylamine (MTDATA); N,N'-diphenyl-N,N'-bis(3-methylphenyl)-[1,1'-biphenyl]-4,4'-diamine (TPD); 1,1-bis[(di-4-tolylamino) phenyl]cyclohexane (TAPC); N,N'-bis(4-methylphenyl)-N,N'-bis(4-ethylphenyl)-[1,1'-(3,3'-dimethyl)biphenyl]-4,4'-diamine (ETPD); tetrakis-(3-methylphenyl)-N,N,N',N'-2,5-phenylenediamine (PDA); α-phenyl-4-N,N-diphenylaminostyrene (TPS); p-(diethylamino)benzaldehyde diphenylhydrazone (DEH); triphenylamine (TPA); bis[4-(N,N-diethylamino)-2-methylphenyl](4-methylphenyl)methane (MPMP); 1-phenyl-3-[p-(diethylamino)styryl]-5-[p-(diethylamino)phenyl] pyrazoline (PPR or DEASP); 1,2-trans-bis(9H-carbazol-9-yl)cyclobutane (DCZB); N,N,N',N'-tetrakis(4-methylphenyl)-(1,1'-biphenyl)-4,4'-diamine (TTB); N,N'-bis(naphthalen-1-yl)-N,N'-bis-(phenyl)benzidine (α-NPB); and porphyrinic compounds, such as copper phthalocyanine. Commonly used hole transporting polymers include, but are not limited to, polyvinylcarbazole, (phenylmethyl)polysilane, poly(dioxythiophenes), polyanilines, and polypyrroles, where such polymers are not doped or combined with fluorinated materials. It is also possible to obtain hole transporting polymers by doping hole transporting molecules such as those mentioned above into polymers such as polystyrene and polycarbonate. In some embodiments, the hole transport material comprises a cross-linkable oligomeric or polymeric material. After the formation of the hole transport layer, the material is treated with radiation to effect cross-linking. In some embodiments, the radiation is thermal radiation.

The hole transport layer 130 can be applied by any deposition technique. In one embodiment, the hole transport layer is applied by a solution deposition method, as described above. In one embodiment, the hole transport layer is applied by a continuous solution deposition method. In one embodiment, the hole transport layer is applied by vapor deposition.

Any organic electroluminescent ("EL") material can be used in the photoactive layer 140, including, but not limited to, small molecule organic fluorescent compounds, fluorescent and phosphorescent metal complexes, conjugated polymers, and mixtures thereof. Examples of fluorescent compounds include, but are not limited to, pyrene, perylene, rubrene, coumarin, derivatives thereof, and mixtures thereof. Examples of metal complexes include, but are not limited to, metal chelated oxinoid compounds, such as tris(8-hydroxyquinolato)aluminum (Alq3); cyclometalated iridium and platinum electroluminescent compounds, such as complexes of iridium with phenylpyridine, phenylquinoline, or phenylpyrimidine ligands as disclosed in Petrov et al., U.S. Patent 6,670,645 and Published PCT Applications WO 03/063555 and WO 2004/016710, and organometallic complexes described in, for example, Published PCT Applications WO 03/008424, WO 03/091688, and WO 03/040257, and mixtures thereof. Electroluminescent emissive layers comprising a charge carrying host material and a metal complex have been described by Thompson et al., in U.S. Patent 6,303,238, and by Burrows and Thompson in published PCT applications WO 00/70655 and WO 01/41512. Examples of conjugated polymers include, but are not limited to poly(phenylenevinylenes), polyfluorenes, poly(spirobifluorenes), polythiophenes, poly(p-phenylenes), copolymers thereof, and mixtures thereof.

The photoactive layer 140 can be applied by any deposition technique. In one embodiment, the photoactive layer is applied by a solution deposition method, as described above. In one embodiment, the photoactive layer is applied by a continuous solution deposition method.

Optional layer 150 can function both to facilitate electron injection/transport, and can also serve as a confinement layer to prevent quenching reactions at layer interfaces. More specifically, layer 150 may promote electron mobility and reduce the likelihood of a quenching reaction if layers 140 and 160 would otherwise be in direct contact. Examples of materials for optional layer 150 include, but are not limited to, metal-chelated oxinoid compounds (e.g., Alq₃ or the like); phenanthroline-based compounds (e.g., 2,9-dimethyl-4,7-diphenyl-1,10-phenanthroline ("DDPA"), 4,7-diphenyl-1,10-phenanthroline ("DPA"), or the like); azole compounds (e.g., 2-(4-biphenylyl)-5-(4-t-butylphenyl)-1,3,4-oxadiazole ("PBD" or the like), 3-(4-biphenylyl)-4-phenyl-5-(4-t-butylphenyl)-1,2,4-triazole ("TAZ" or the like); other similar compounds; or any one or more combinations thereof. Alternatively, optional layer 150 may be inorganic and comprise BaO, LiF, Li₂O, or the like.

The cathode 160, is an electrode that is particularly efficient for injecting electrons or negative charge carriers. The cathode layer 160 can be any metal or nonmetal having a lower work function than the first electrical contact layer (in this case, the anode layer 110). In one embodiment, the term "lower work function" is intended to mean a material having a work function no greater than about 4.4 eV. In one embodiment, "higher work function" is intended to mean a material having a work function of at least approximately 4.4 eV.

Materials for the cathode layer can be selected from alkali metals of Group 1 (e.g., Li, Na, K, Rb, Cs,), the Group 2 metals (e.g., Mg, Ca, Ba, or the like), the Group 12 metals, the lanthanides (e.g., Ce, Sm, Eu, or the like), and the actinides (e.g., Th, U, or the like). Materials such as aluminum, indium, yttrium, and combinations thereof, may also be used. Specific non-limiting examples of materials for the cathode layer 160 include, but are not limited to, barium, lithium, cerium, cesium, europium, rubidium, yttrium, magnesium, samarium, and alloys and combinations thereof.

The cathode layer 160 is usually formed by a chemical or physical vapor deposition process.

In other embodiments, additional layer(s) may be present within organic electronic devices.

The choice of materials for each of the component layers is preferably determined by balancing the goals of providing a device with high device efficiency with device operational lifetime considerations, fabrication time and complexity factors and other considerations appreciated by persons skilled in the art. It will be appreciated that determining optimal components, component configurations, and compositional identities would be routine to those of ordinary skill of in the art.

In one embodiment, the different layers have the following range of thicknesses: anode 110, 500-5000 Å, in one embodiment 1000-2000Å; the buffer bilayer 120, 100-4000 Å, with the hole injection layer 122, 50-2000 Å, in one embodiment 200-1000 Å, and the hole transport layer 124, 50-2000 Å, in one embodiment 200-1000 Å; photoactive layer 130, 10-2000 Å, in one embodiment 100-1000 Å; optional electron transport layer 140, 50-2000 Å, in one embodiment 100-1000 Å; cathode 150, 200-10000 Å, in one embodiment 300-5000 Å. The location of the electron-hole recombination zone in the device, and thus the emission spectrum of the device, can be affected by the relative thickness of each layer. Thus the thickness of the electron-transport layer should be chosen so that the electron-hole recombination zone is in the light-emitting layer. The desired ratio of layer thicknesses will depend on the exact nature of the materials used.

In operation, a voltage from an appropriate power supply (not depicted) is applied to the device 100. Current therefore passes across the layers of the device 100. Electrons enter the organic polymer layer, releasing photons. In some OLEDs, called active matrix OLED displays, individual deposits of photoactive organic films may be independently excited by the passage of current, leading to individual pixels of light emission. In some OLEDs, called passive matrix OLED displays, deposits of photoactive organic films may be excited by rows and columns of electrical contact layers.

### EXAMPLES

The concepts described herein will be further described in the following examples, which do not limit the scope of the invention described in the claims.

### General procedure for film sample preparation and Kelvin probe measurement

Film samples of Kelvin probe measurement were made by spin-coating of an aqueous dispersion, or a polymer solution as illustrated in Examples and Comparative Examples on 30 mm x 30 mm glass/ITO substrates. For the bilayer film samples, an aqueous dispersion was first spin-coated on ITO substrates before top-coated with a hole transporting polymer solution. ITO/glass substrates consist of 15 mm x 20 mm ITO area at the center having ITO thickness of 100 to 150nm. At one corner of 15mmx20mm ITO area, ITO film surface extended to the edge of the glass/ITO serves as electrical contact with Kelvin probe electrode. Prior to spin coating, ITO/glass substrates were cleaned and the ITO sides were subsequently treated with Oxygen/plasma for 15 minutes at 0.3Torr at 300watts or UV-ozone for 10 minutes. Once spin-coated, the deposited materials on the corner of the extended ITO film were removed with a Q-tip wetted with either water or Toluene. The exposed ITO pad was for making contact with Kelvin probe electrode. The deposited films were then baked as illustrated in Examples and Comparative Examples. The baked film samples were then placed on a glass jug flooded with nitrogen before capped with a lid before measurement.

For work function, or energy potential measurement, ambient-aged gold film was measured first as a reference prior to measurement of samples. The gold film on a same size of glass piece was placed in a cavity cut out at the bottom of a square steel container. On the side of the cavity, there are four retention clips to keep sample piece firmly in place. One of the retention clips is attached with electrical wire for making contact with the Kelvin probe. The gold film was facing up while a Kelvin probe tip protruded from the center of a steel lid was lowered to above the center of the gold film surface. The lid was then screwed tightly onto the square steel container at four corners. A side port on the square steel container was connected with a tubing for allowing nitrogen to sweep the Kelvin probe cell continuously while a nitrogen exit port capped with a septum in which a steel needle is inserted for maintaining ambient pressure. The probe settings were then optimized for the probe and only height of the tip was changed through entire measurement. The Kelvin probe was connected to a McAllister KP6500 Kelvin Probe meter having the following parameters: 1) frequency: 230; 2) amplitude: 20; 3) DC offset: varied from sample to sample; 4) upper backing potential: 2 volt; 5) lower backing potential: -2 volt; 6) scan rate: 1; 7) trigger delay: 0; 8) acquisition(A)/data(D) points:1024; 9) A/D rate: 12405 @19.0 cycles; 10) D/A: delay: 200; 11) set point gradient: 0.2; 12) step size: 0.001; 13) maximum gradient deviation: 0.001. As soon as the tracking gradient stabilized, the contact potential difference ("CPD") in volt between gold film was recorded. The CPD of gold was then referencing the probe tip to (4.7-CPD)eV. The 4.7eV (electron volt) is work function of ambient aged gold film surface [Surface Science, 316, (1994), P380]. The CPD of gold was measured periodically while CPD of samples were being determined. Each sample was loaded into the cavity in the same manner as gold film sample with the four retention clips. On the retention clip making electrical contact with the sample care was taken to make sure good electrical contact was made with the exposed ITO pad at one corner. During the CPD measurement a small stream of nitrogen was flowed through the cell continuously without disturbing the probe tip. Once CPD of sample was recorded, the sample energy potential was then calculated by adding CPD of the sample to the difference of 4.7eV and CPD of gold.

Note that not all of the activities described above in the general description or the examples are required, that a portion of a specific activity may not be required, and that one or more further activities may be performed in addition to those described. Still further, the order in which activities are listed are not necessarily the order in which they are performed.

In the foregoing specification, the concepts have been described with reference to specific embodiments. However, one of ordinary skill in the art appreciates that various modifications and changes can be made without departing from the scope of the invention as set forth in the claims below. Accordingly, the specification and figures are to be regarded in an illustrative rather than a restrictive sense, and all such modifications are intended to be included within the scope of invention.

Benefits, other advantages, and solutions to problems have been described above with regard to specific embodiments. However, the benefits, advantages, solutions to problems, and any feature(s) that may cause any benefit, advantage, or solution to occur or become more pronounced are not to be construed as a critical, required, or essential feature of any or all the claims.

The use of numerical values in the various ranges specified herein is stated as approximations as though the minimum and maximum values within the stated ranges were both being preceded by the word "about." In this manner slight variations above and below the stated ranges can be used to achieve substantially the same results as values within the ranges. Also, the disclosure of these ranges is intended as a continuous range including every value between the minimum and maximum average values including fractional values that can result when some of components of one value are mixed with those of different value. Moreover, when broader and narrower ranges are disclosed, it is within the contemplation of this invention to match a minimum value from one range with a maximum value from another range and vice versa.

It is to be appreciated that certain features are, for clarity, described herein in the context of separate embodiments, may also be provided in combination in a single embodiment. Conversely, various features that are, for brevity, described in the context of a single embodiment, may also be provided separately or in any subcombination.

## Claims

1. A process for forming an organic electronic device, comprising:
forming a first layer comprising an electrically conductive material and a fluorinated acid polymer, said first layer having a first surface energy;
forming a second layer over the first layer, said second layer having a second surface energy which is greater than the first surface energy;
removing selected portions of the second layer, resulting in uncovered areas of the first layer;
forming a third layer over the uncovered areas of the first layer.

2. The process of Claim 1, wherein the first layer has a work function greater than 5.2 eV.

3. The process of Claim 1, wherein the first layer is a hole injection layer having a work function greater than 5.2 eV, the second layer is a hole transport layer, and the third layer is a photoactive layer.

4. The process of Claim 1, wherein the first layer comprises at least one electrically conductive polymer doped with at least one fluorinated acid polymer.

5. The process of Claims 1 or 4, wherein the electrically conductive polymer is selected from the group consisting of polythiophenes, polyselenophenes, poly(tellurophenes), polypyrroles, polyanilines, polycyclic aromatic polymers, and copolymers thereof.

6. The process of Claims 1, 4 or 5 wherein the fluorinated acid polymer has a perfluorinated carbon backbone and side chains represented by the formula
-(O-CF₂CFR_{f}³)ₐ-O-CF₂CFR_{f}⁴SO₃E⁵
wherein R_{f}³ and R_{f}⁴ are independently selected from F, Cl or a perfluorinated alkyl group having 1 to 10 carbon atoms, a = 0, 1 or 2, and E⁵ is H.

7. The process of Claims 1, 4, 5 or 6 wherein the first layer comprises a conductive material selected from the group consisting of inorganic oxides, conducting polymers and combinations thereof.

8. The process of Claim 7, wherein the conducting polymer is in admixture with a fluorinated acid polymer.

9. The process of Claim 5, wherein the acid polymer has a fluorinated olefin backbone.

10. The process of Claim 1, wherein the second layer is crosslinkable.

11. The process of Claim 1, wherein the fluorinated acid polymer is a colloid-forming acid.

12. The process of Claim 11, wherein the acid polymer is an FSA (fluorinated sulfonic acid) polymer.

13. The process of any one of the preceding claims, wherein the second layer comprises a hole transport material selected from the group consisting of polymeric materials, non-polymeric materials, and combinations thereof.

14. The process of any one of the preceding claims, wherein the third layer comprises a photoactive material.

15. The process of any one of the preceding claims, wherein the third layer comprises an electroluminescent material.

## Patentansprüche

1. Verfahren zum Bilden einer organischen elektronischen Vorrichtung, umfassend:
das Bilden einer ersten Schicht umfassend ein elektrisch leitfähiges Material und ein fluoriertes saures Polymer, wobei die erste Schicht eine erste Oberflächenenergie aufweist;
das Bilden einer zweiten Schicht über der ersten Schicht, wobei die zweite Schicht eine zweite Oberflächenenergie aufweist, die höher ist als die erste Oberflächenenergie;
das Entfernen ausgewählter Teile der zweiten Schicht, was zu unbedeckten Bereichen der ersten Schicht führt;
das Bilden einer dritten Schicht über den unbedeckten Bereichen der ersten Schicht.

2. Verfahren nach Anspruch 1, wobei die erste Schicht eine Arbeitsfunktion von mehr als 5,2 eV aufweist.

3. Verfahren nach Anspruch 1, wobei die erste Schicht eine Lochinjektionsschicht ist, die eine Arbeitsfunktion von mehr als 5,2 eV aufweist, die zweite Schicht eine Lochtransportschicht ist und die dritte Schicht eine photoaktive Schicht ist.

4. Verfahren nach Anspruch 1, wobei die erste Schicht mindestens ein elektrisch leitfähiges Polymer umfasst, das mit mindestens einem fluorierten sauren Polymer dotiert ist.

5. Verfahren nach den Ansprüchen 1 oder 4, wobei das elektrisch leitfähige Polymer aus der Gruppe ausgewählt ist bestehend aus Polythiophenen, Polyselenophenen, Poly(tellurophenen), Polypyrrolen, Polyanilinen, polycyclischen aromatischen Polymeren, und Copolymeren davon.

6. Verfahren nach den Ansprüchen 1, 4 oder 5, wobei das fluorierte saure Polymer eine perfluorierte Kohlenstoffrückgratkette und Seitenketten aufweist, die durch die Formel
-(O-CF₂CFR_{f}³)ₐ-O-CF₂CFR/SO₃E⁵
dargestellt sind, wobei R_{f}³ und R_{f}⁴ unabhängig unter F, Cl oder einer perfluorierten Alkylgruppe ausgewählt werden, die 1 bis 10 Kohlenstoffatome aufweist, a = 0, 1 oder 2 ist und E⁵ H ist.

7. Verfahren nach den Ansprüchen 1, 4, 5 oder 6, wobei die erste Schicht ein leitfähiges Material umfasst ausgewählt aus der Gruppe bestehend aus anorganischen Oxiden, leitfähigen Polymeren und Kombinationen davon.

8. Verfahren nach Anspruch 7, wobei das leitfähige Polymer in einer Mischung mit einem fluorierten sauren Polymer vorliegt.

9. Verfahren nach Anspruch 5, wobei das saure Polymer eine fluorierte Olefinrückgratkette aufweist.

10. Verfahren nach Anspruch 1, wobei die zweite Schicht vernetzbar ist.

11. Verfahren nach Anspruch 1, wobei das fluorierte saure Polymer eine kolloidbildende Säure ist.

12. Verfahren nach Anspruch 11, wobei das saure Polymer ein FSA-Polymer (Polymer von fluorierter Sulfonsäure) ist.

13. Verfahren nach einem der vorhergehenden Ansprüche, wobei die zweite Schicht ein Lochtransportmaterial umfasst ausgewählt aus der Gruppe bestehend aus Polymermaterialien, Nichtpolymermaterialien und Kombinationen davon.

14. Verfahren nach einem der vorhergehenden Ansprüche, wobei die dritte Schicht ein photoaktives Material umfasst.

15. Verfahren nach einem der vorhergehenden Ansprüche, wobei die dritte Schicht ein elektrolumineszierendes Material umfasst.

## Revendications

1. Procédé pour former un dispositif électronique organique, consistant à:
former une première couche comprenant un matériau conduisant l'électricité et un polymère d'acide fluoré, ladite première couche ayant une première énergie de surface;
former une deuxième couche sur la première couche, ladite deuxième couche ayant une deuxième énergie de surface qui est supérieure à la première énergie de surface;
éliminer des parties choisies de la deuxième couche, ce qui fait apparaître des zones découvertes de la première couche;
former une troisième couche sur les zones découvertes de la première couche.

2. Procédé selon la revendication 1, dans lequel la première couche a une valeur de travail d'extraction supérieure à 5,2 eV.

3. Procédé selon la revendication 1, dans lequel la première couche est une couche d'injection de trous ayant une valeur de travail d'extraction supérieure à 5,2 eV, la deuxième couche est une couche de transport de trous, et la troisième couche est une couche photoactive.

4. Procédé selon la revendication 1, dans lequel la première couche comprend au moins un polymère conduisant l'électricité dopé avec au moins un polymère d'acide fluoré.

5. Procédé selon les revendications 1 ou 4, dans lequel le polymère conduisant l'électricité est choisi dans le groupe constitué des polythiophènes, des polysélénophènes, des poly(tellurophènes), des polypyrroles, des polyanilines, des polymères aromatiques polycycliques, et des copolymères de ceux-ci.

6. Procédé selon les revendications 1, 4 ou 5 dans lequel le polymère d'acide fluoré a un squelette carboné perfluoré et des chaînes latérales représentées par la formule
-(O-CF₂CFR_{f}³)ₐ-O-CF₂CFR_{f}⁴SO₃E⁵
dans laquelle R_{f}³ et R_{f}⁴ sont indépendamment choisis parmi F, Cl ou un groupe alkyle perfluoré ayant de 1 à 10 atomes de carbone, a = 0, 1 ou 2, et E⁵ représente H.

7. Procédé selon les revendications 1, 4, 5 ou 6 dans lequel la première couche comprend un matériau conducteur choisi dans le groupe constitué des oxydes inorganiques, des polymères conducteurs et des combinaisons de ceux-ci.

8. Procédé selon la revendication 7, dans lequel le polymère conducteur est mélangé avec un polymère d'acide fluoré.

9. Procédé selon la revendication 5, dans lequel le polymère d'acide a un squelette oléfinique fluoré.

10. Procédé selon la revendication 1, dans lequel la deuxième couche est réticulable.

11. Procédé selon la revendication 1, dans lequel le polymère d'acide fluoré est un acide formant un colloïde.

12. Procédé selon la revendication 11, dans lequel le polymère d'acide est un polymère de FSA (acide sulfonique fluoré).

13. Procédé selon l'une quelconque des revendications précédentes, dans lequel la deuxième couche comprend un matériau de transport de trous choisi dans le groupe constitué des matériaux polymères, des matériaux non polymères, et des combinaisons de ceux-ci.

14. Procédé selon l'une quelconque des revendications précédentes, dans lequel la troisième couche comprend un matériau photoactif.

15. Procédé selon l'une quelconque des revendications précédentes, dans lequel la troisième couche comprend un matériau électroluminescent.
